# EUROPEAN PATENT APPLICATION

(11) **EP 2 801 991 A1**
(43) Date of publication of application: **12.11.2014**
(21) Application number: 13166703.2
(22) Date of filing: 06.05.2013
(51) Int. Cl.: H01G 9/20, C07F 15/00

(54) **Dye-sensitized solar cells, metal complexes for the same, and ligands therefor**

(71) Applicant: Solvay SA, 1120 Bruxelles (BE)
(72) Inventor: Miyaji, Taichi, Japan, 2520004 (JP); Nazeeruddin, Mohammad Khaja, CH-1024 ECUBLENS (CH); Graetzel, Michael, 1025 SAINT SULPICE (CH); Frey, Julien Edouard, 1400 Yverdon-les-Bains (CH); Polander, Lauren E., Atlanta, GA Georgia 30308 (US); Yella, Aswani, 1025 Lausanne (CH)
(74) Representative: Mross, Stefan P.M.

(57) **Abstract**

Provided are dye-sensitized solar cells, comprising a metal complex at least comprising a particular bidentate ligand, as a sensitizing-dye, and a cobalt complex, as a redox mediator. The present invention also concerns metal complex dyes for the same, and ligands therefor.

## Description

### TECHNICAL FIELD

The present invention relates to dye-sensitized solar cells comprising specific metal complex as a sensitizing-dye and a cobalt complex as a redox mediator, metal complex dyes for the same, and bidentate ligands therefor.

### BACKGROUND OF THE INVENTION

Conventional solar cells convert light into electricity by exploiting the photovoltaic effect that exists at semiconductor junctions. In other words, the commercial solar cells absorb energy from visible light and convert excited charge carriers thereof to electric energy. At present, the main commercial solar cells are silicon-based solar cells. For the silicon-based solar cell, there are shortcomings in that high energy costs for material processing is required and many problems to be addressed such as environmental burdens and cost and material supply limitations are involved. For amorphous silicon solar cells, there are also shortcomings in that energy conversion efficiency decreases when used for a long time, due to deterioration in a short period.

One of the low-cost organic solar cells is a dye-sensitized solar cell (DSSC) which is formed based on a semiconductor sensitized by a dye to absorb incoming light to produce excited electron, an electrode connected to the semiconductor, a counter electrode and an electrolyte usually comprising the triiodide/iodide (I₃⁻/I⁻) redox mediator.

The triiodide/iodide redox mediator has several drawbacks from both scientific and commercial point of views. US 7,019,138 B2 discloses certain cobalt complexes as a candidate of alternative redox mediator.

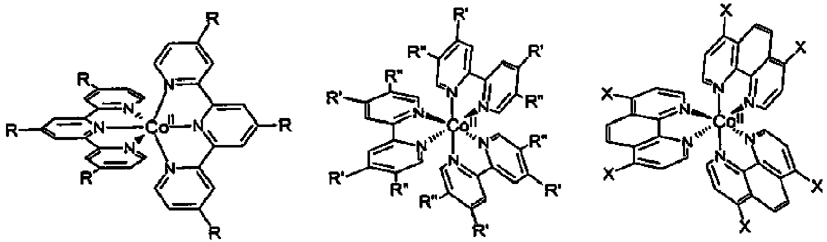

| | |
|---|---|
| R = ethyl (te-terpy) | R' = *t*-butyl, R" = H (dtb-bpy) |
| R = *t*-butyl (ttb-terpy) | R' = COO-*t*-butyl, R" = H (dtb-est) |
| R' = H, R" = H (bpy) | R' = phenyl, R" = H (dp-bpy) |
| R' = CH₃, R" = H (4,4'-dmb) | R' = 3-pentyl, R" = H (d3p-bpy) |
| R' = H, R" = CH₃ (5,5'-dmb) | R' = nonyl, R" = H (dn-bpy) |
| R' = CH₃, R" = CH₃ (tm-bpy) | X = H (phen) |
| R'= 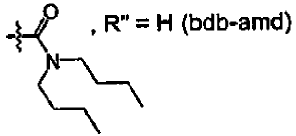 | X = phenyl (phen-phen) |

In spite of their advantages, the cobalt complex based redox mediators generally have poor compatibility with sensitizing-dye molecules having metal complex structure, such as N719.

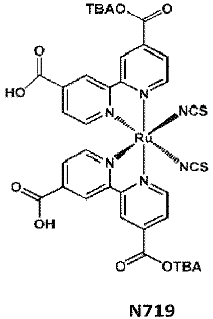

### DESCRIPTION OF THE INVENTION

The purpose of the present invention is to provide metal complex dyes which show superior compatibility with cobalt complex based redox mediators. Another purpose of the present invention is to provide dye-sensitized solar cells based on a combination of metal complex sensitizing-dye and cobalt complex based redox mediator, which has advantages in terms of performance in a DSSC.

The present invention therefore relates to a dye-sensitized solar cell, comprising a metal complex and a cobalt mediator wherein said metal complex comprises at least one bidentate ligand comprising a first aromatic ring comprising at least one nitrogen atom as ring atom and a second aromatic ring connected to the first aromatic ring, said bidentate ligand being substituted by at least one substituent having 4 or more carbon atoms, wherein the first aromatic ring is coordinated to the metal through a metal-nitrogen bond and the second aromatic ring is coordinated to the metal through a metal-carbon bond.

Indeed, it has been surprisingly found by the present inventors that the metal complex comprising at least one bidentate ligand comprising certain moiety(ies) along with particular substituent(s) shows superior compatibility with cobalt complex based redox mediator. This advantage allows the use of cobalt complex as redox mediator in DSSC system in which metal complex dye molecule, particularly ruthenium complex dye, is adopted as a sensitizing-dye, without causing a significant decrease in the performances of the system compared with that of a system adopting the conventional triiodide/iodide couple.

The metal complex dyes usually have better total performance, such as in terms of efficiency and/or stability, than other type of dyes, such as organic dyes having D-π-A structure (wherein D is donor group, π is bridge group and A is acceptor group), or macrocyclic dyes, for example porphyrin dyes and phthalocyanine dyes. However, it has been understood that the conventional metal complex dyes have poor compatibility with cobalt complex based redox mediator, despite of the advantages of using such redox mediator. Such advantages of cobalt complex based redox mediator over triiodide/iodide system include non-corrosive characteristic, high transmittance (and colorless), nice tunability, and high Voc. The present inventors have found that certain metal complex dyes can be used with cobalt complex based redox mediator with high compatibility, by introducing particular ligand having specific structure in the metal complex dyes. Without wishing to be bound by any theory, such particular ligands were found to be convenient to tune the energy levels, particularly highest occupied molecular orbital (HOMO) energy level.

In the present invention, "redox mediator" is understood to denote in particular molecules or ions which mediate electron transfer from a counter electrode to an oxidized dye by their reversible reduction-oxidation function. Particular examples of the cobalt redox mediator include those disclosed in US7019138, EP2492277 and EP2511924, which are incorporated by references herein.

In the present invention, "alkyl groups" is understood to denote in particular a straight chain, branched chain, or cyclic hydrocarbon groups usually having from 1 to 20 carbon atoms. Examples of alkyl groups include methyl, ethyl, propyl, isopropyl, butyl, isobutyl, sec-butyl, tert-butyl, pentyl, neopentyl, hexyl, cyclopropyl, cyclobutyl, cyclopentyl, and cyclohexyl.

In the present invention, "alkoxy groups" is understood to denote in particular a straight chain, branched chain, or cyclic hydrocarbon groups usually having from 1 to 20 carbon atoms singularly bonded to oxygen (Alk-O-).

In the present invention, "aryl groups" is understood to denote in particular any functional group or substituent derived from an aromatic ring. In particular, the aryl groups can have 6 to 20 carbon atoms (preferably 6 to 12 due to its easiness of synthesis at a low cost) in which some or all of the hydrogen atoms of the aryl group may or may not be substituted with other groups, especially alkyl groups, alkoxy groups, aryl groups, aryloxy groups, thioalkoxy groups, heterocycles, amino groups or hydroxyl groups. The aryl groups are preferably optionally substituted phenyl groups, naphthyl groups, anthryl group and phenanthryl group.

In the present invention, "aryloxy groups" is understood to denote in particular the aryl group as defined above singularly bonded to oxygen (Ar-O-).

In the present invention, "heterocycles" is understood to denote in particular a cyclic compound, which has at least one heteroatom as a member of its one or more rings. Frequent heteroatoms within the ring include sulfur, oxygen and nitrogen. The heterocycles can be either saturated or unsaturated, and may be 3-membered, 4-membered, 5-membered, 6-membered or 7-membered ring. The heterocycles can be further fused with other one or more ring systems. Examples of the heterocycles include pyrrolidines, oxolanes, thiolanes, pyrroles, furans, thiophenes, piperidines, oxanes, thianes, pyridines, pyrans, pyrazoles, imidazoles, and thiopyrans, and their derivatives. The heterocycles can further be substituted by other groups, such as alkyl groups, alkoxy groups, aryl groups, thioalkoxy groups, amino groups or aryloxy groups as defined above.

In the present invention, "amino groups" is understood to denote in particular aliphatic amines or aromatic amines and encompass compounds comprising one or multiple amino groups. The amino groups can be primary amines, secondary amines and tertiary amines, wherein one or more hydrogen atoms may or may not be substituted with other groups, such as alkyl groups or aryl groups.

In the present invention, "halogenated" is understood to denote in particular at least one of the hydrogen atoms of the following chemical group has been replaced by a halogen atom, preferably selected from fluorine and chlorine, more preferably fluorine. If all of the hydrogen atoms have been replaced by halogen atoms, the halogenated chemical group is perhalogenated. For instance, "halogenated alkyl groups" include (per)fluorinated alkyl groups such as (per)fluorinated methyl, ethyl, propyl, isopropyl, butyl, isobutyl, *sec*-butyl or *tert*-butyl; and for instance -CF₃, -C₂F₅, heptafluoroisopropyl (-CF(CF₃)₂), hexafluoroisopropyl (-CH(CF₃)₂) or -CF₂(CF₂)₄CF₃. Non-limiting example of "halogenated aryl groups" include -C₆F₅.

In the present invention, "anchoring groups" is understood to denote in particular groups that will allow attachment of the dyes onto a semiconductor, such as TiO₂ and TiOF₂. Suitable anchoring groups are for instance selected from, but not limited to, the group consisting of -COOH, -PO₃H₂, -P(=O)(Ra)(OH) (wherein Ra is selected from the groups consisting of optionally branched C1-C18 alkyl groups and optionally substituted C5-C12 aryl groups, and halogenated derivatives thereof), -PO₄H₂, -PO₂HRb (wherein Rb is selected from alkyl groups or aryl groups), -SO₃H, -CONHOH, -NO₂, acetylacetonate, acrylic acid derivatives, malonic acid derivatives, rhodanine-3-acetic acid, propionic acid, deprotonated forms of the aforementioned groups, salts of said deprotonated forms, and chelating groups with π-conducting character. More preferred anchoring groups are -COOH or the salts of deprotonated -COOH. The acrylic acid derivatives may for instance be selected from groups of formula -CH=C(Rc)-COOH where Rc is selected from H, CN, -COOH and optionally halogenated alkyl groups, preferably from H, CN, -COOH and CF₃. The malonic acid derivatives suitable as anchoring groups may for example be selected from groups of formula -CRd=C(COOH)₂ where Rd is selected from H and optionally halogenated alkyl groups, especially from H and optionally fluorinated alkyl groups. Especially preferable salts of -COOH are for instance ammonium salts, or alkali metal salts, more preferably -COOTBA (wherein, TBA indicates tetrabutylammonium).

In the present invention, the bidentate ligand is preferably composed of a first aromatic ring and a second aromatic ring connected thereto. In this case, the first aromatic ring generally comprises at least one nitrogen atom as its ring atom and is coordinated to a center metal of the metal complex through a metal-nitrogen bond. Accordingly, the first aromatic ring is a heterocyclic aromatic ring. Particular examples of the first aromatic ring include pyridines, pyrazoles, and imidazoles. The second aromatic ring is connected to the first aromatic ring and is coordinated to a center metal of the metal complex through a metal-carbon bond. The second aromatic ring may or may not contain a heteroatom.

In one embodiment of the present invention, the bidentate ligand of the metal complex comprises a moiety selected from the group consisting of formulae (L1), (L2) and (L3) : 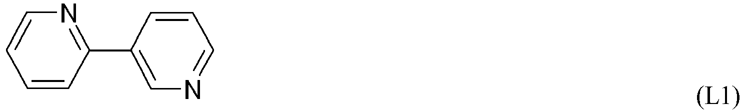 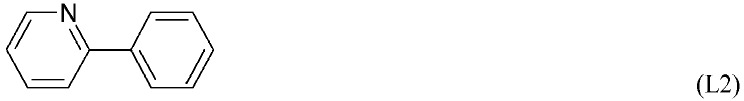 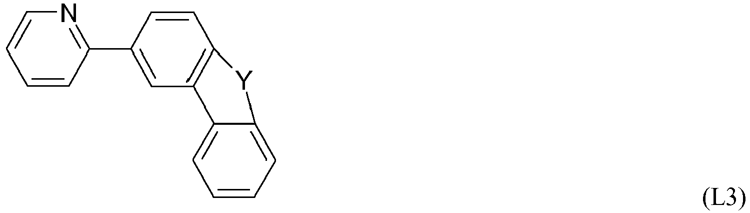 wherein Y is selected from the group consisting of C, N, O, P, P(O), S, Se, B and S(O₂).

Preferably, a metal complex comprising at least one bidentate ligand comprising a moiety of formulae (L1) is used in the present invention.

In another embodiment of the present invention, the bidentate ligand has a structure selected from the group consisting of the formulae (L1-1), (L2-1), (L2-2), (L2-3), (L2-4), (L2-5), (L3-1), (L3-2), (L3-3) and (L3-4) : 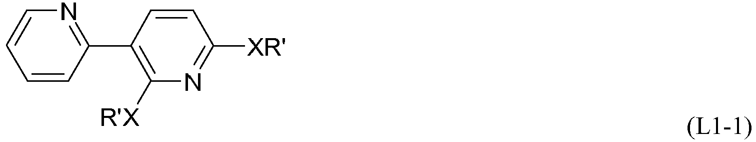 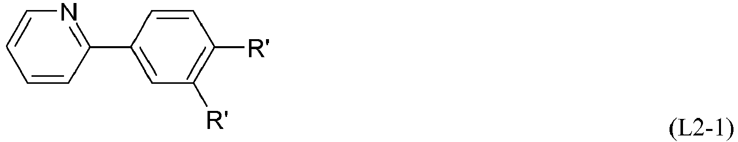 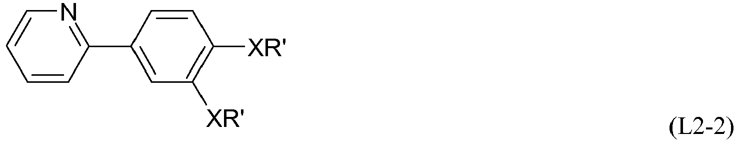 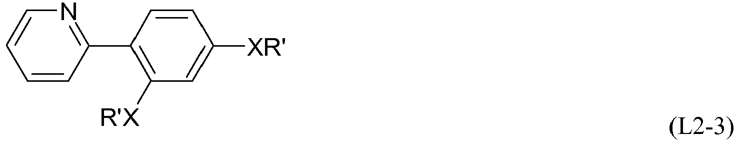 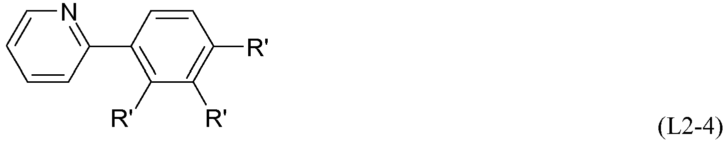 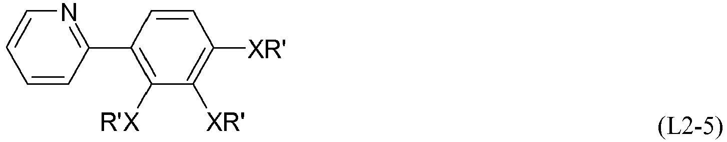 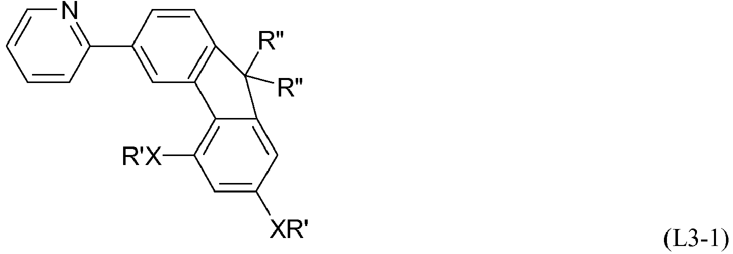 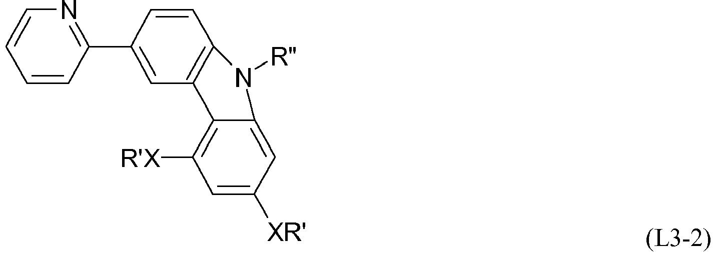 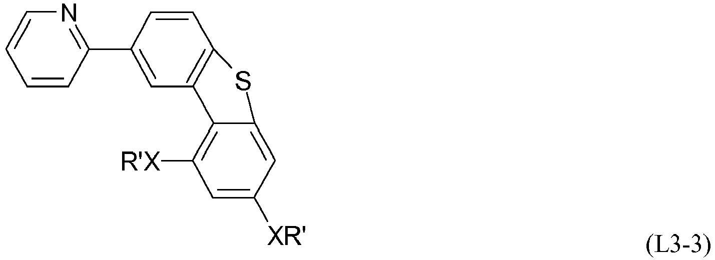 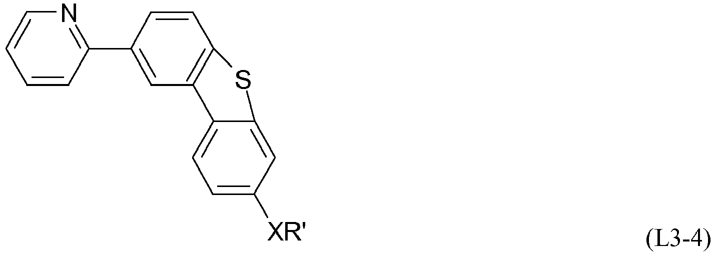 wherein X is independently selected from the group consisting of NR', O and S, preferably X is O, R' is independently selected from the group consisting of alkyl groups, halogenated alkyl groups, aryl groups, halogenated aryl groups, and any derivatives of the foregoing groups wherein at least one of the carbon atom in the foregoing group is replaced by heteroatom, such as N, O and S, preferably by N or O, and any combination thereof, and R" is independently selected from the group consisting of hydrogen, alkyl groups, halogenated alkyl groups, aryl groups, halogenated aryl groups, and any derivatives of the foregoing groups wherein at least one of the carbon atom in the foregoing group is replaced by heteroatom, such as N, O and S, preferably by N or O, and any combination thereof, provided at least one R' comprises 4 or more carbon atoms.

More preferably, the metal complex comprises a bidentate ligand of the formula (L1-1). Yet more preferably, the metal complex comprises a bidentate ligand of the formula (L1-1) wherein X is O.

In the present invention, the bidentate ligand of the metal complex preferably comprises at least one bulky group as its substituents. Examples of the bulky group include any substituent having 4 or more carbon atoms, preferably 4 to 18 carbon atoms, more preferably 6, 7, 8, 9, 10, 11 or 12 carbon atoms. More particularly, the examples of the bulky group include any substituent selected from the group consisting of alkyl groups, halogenated alkyl groups, alkoxy groups, halogenated alkoxy groups, aryl groups, halogenated aryl groups, aryloxy groups, halogenated aryloxy groups, any derivatives of the foregoing groups wherein at least one of the carbon atom in the foregoing group is replaced by heteroatom, such as N, O and S, preferably by N or O, of which carbon atoms is 4 or more, preferably 4 to 18, more preferably 6, 7, 8, 9, 10, 11 or 12.

According to preferred embodiment of the present invention, the bidentate ligand comprising a moiety selected from the group consisting of formulae (L1), (L2) and (L3), preferably of formulae (L1-1), (L2-1), (L2-2), (L2-3), (L2-4), (L2-5), (L3-1), (L3-2), (L3-3) and (L3-4) comprises least one bulky group. Thus, the bidentate ligand comprising the moiety may comprise any substituent as defined for the bulky group, such as optionally halogenated alkyl group or optionally halogenated alkoxy group having 4 or more carbon atoms. Further, in a further embodiment of the present invention, at least one R' comprises 4 or more carbon atoms, preferably 4 to 18 carbon atoms, more preferably 6, 7, 8, 9, 10, 11 or 12 carbon atoms.

In a specific embodiment according to the present invention, the cobalt complex has the formula (A) :

[L¹ₐCoL²_{b}](X_{c}) (A)

wherein Co is cobalt; a and b are independently integer from 0 to 6, c is integer from 0 to 3 ; each X is independently a counter-anion selected from borates or phosphates ; and each L¹ is independently selected from the group consisting of unsubstituted or substituted bipyridine ligands and unsubstituted or substituted terpyridine ligands, and each L² is independently a co-ligand. In the present invention, the co-ligand (L²), in case it exists in the cobalt complex, is selected from the group consisting of Cl-, Br-, I-, CN-, NCO-, NCS-, NCSe-, amino groups, phosphate groups, ClO₄⁻, PF₆⁻, borates such as [BF₄]⁻, tetracyanoborate ([B(CN)₄]⁻), [B(Ph)₄]⁻, [B(C₆F₅)₄]⁻ bis(trifluoromethanesulfonyl)imide (TFSI⁻), bis(fluorosulfonyl)imide (FSI⁻), and any combination thereof, preferably ClO₄⁻, PF₆⁻, [BF₄]⁻, ([B(CN)₄]⁻), TFSI⁻ or FSI⁻.

In a further specific embodiment according to the present invention, the cobalt mediator comprises at least one ligand selected from the group consisting of the following structures. 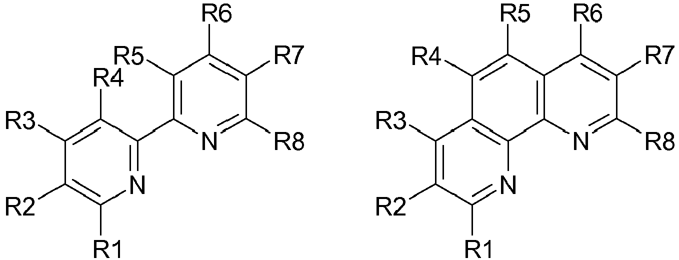 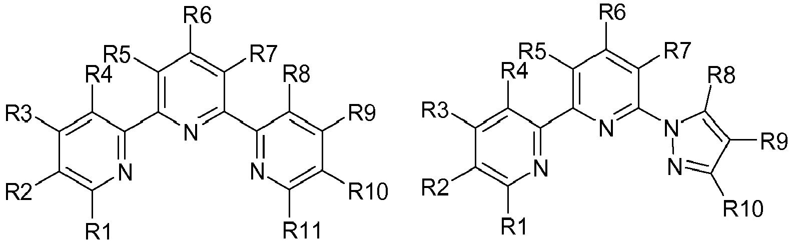 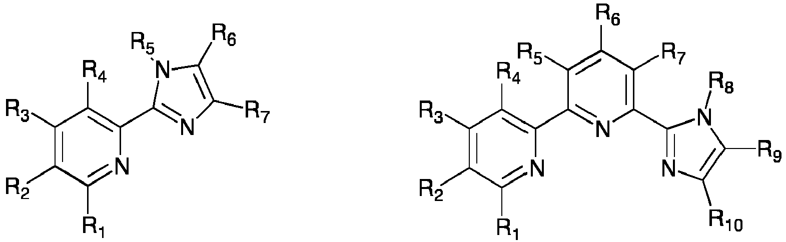 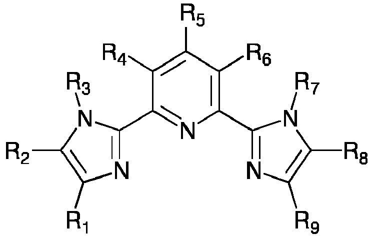 wherein R1, R2, R3, R4, R5, R6, R7, R8, R9, R10 and R11 are independently selected from the group consisting of hydrogen, halogens, in particular fluorine, amino groups, NO₂, CN, alkyl groups, halogenated alkyl groups, aryl groups, halogenated aryl groups, particularly hydrogen, fluorine, alkyl groups, and fluorinated alkyl groups, more particularly hydrogen, fluorine, methyl group, ethyl group, partially or per-fluorinated methyl group, and partially or per-fluorinated ethyl groups.

The cobalt complexes described herein are especially suitable for use in photoelectric conversion devices, particularly in dye-sensitized solar cells.

In a particularly preferred embodiment of the present invention, the metal complex suitable for the use as a sensitizing-dye in DSSC has the formula (I) :

MLaLbLc (I)

wherein M represents a metal belonging to Group 6, 8, 9, 10 or 11 of the long-format Periodic Table, preferably ruthenium; La and Lb are independently selected from bipyridine ligands, in which at least one of La and Lb correspond to the formula (B) or the formula (II) below : 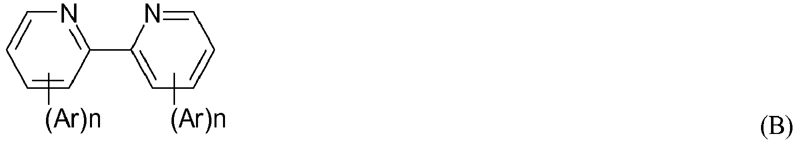 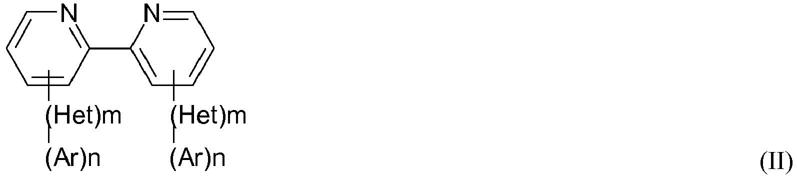 wherein Het is independently selected from a bridge selected from the group consisting of aromatic amine groups, heteroatoms, alkenyl groups, aryl groups, and heterocycles, in particular thiophene, oligothiophenes, ethylenedioxythiophenes (EDOT), oligo-EDOTs, cyclopentanedithiophenes (CPDT), and any combination thereof, preferably sulfur and thiophene, Ar is independently selected from the group consisting of hydrogen, halogens, cyano, alkyl groups, halogenated alkyl groups, alkoxy groups, halogenated alkoxy groups, aryl groups, halogenated aryl groups, aryloxy groups, halogenated aryloxy groups, amino groups, halogenated amino groups, and NO₂, m is independently 1, 2, 3, or 4, and n is 1, 2, 3, or 4; and Lc is the ligand comprising a moiety selected from the group consisting of formulae (L1), (L2) and (L3).

In an especially preferred embodiment of the present invention, the formula (B) has the formula (B-1), (B-2), (B-3), (B-4), (B-5) or (B-6) below : 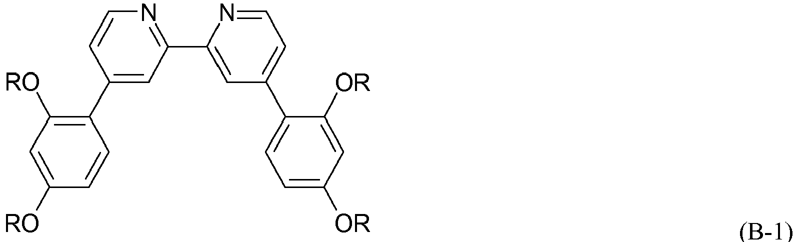 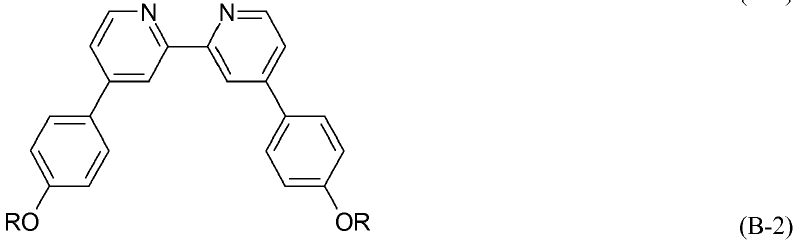 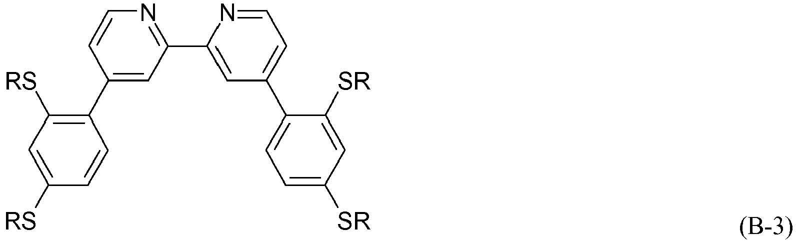 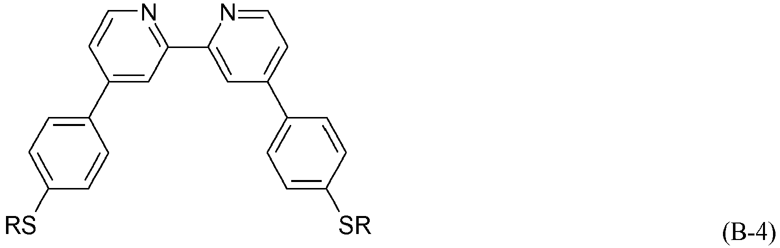 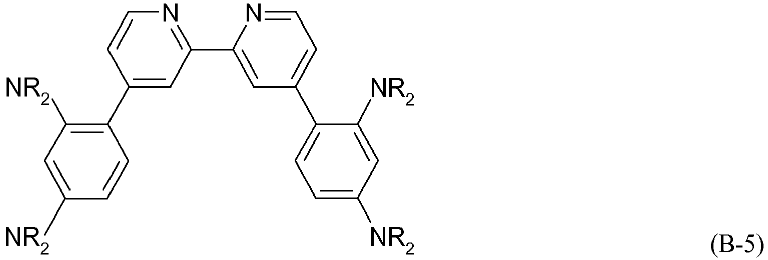 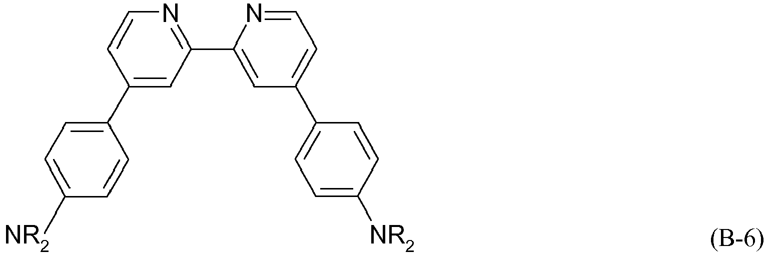 wherein R is independently selected from alkyl groups, preferably butyl, pentyl, hexyl, heptyl octyl, nonyl or decyl group, especially hexyl group.

As example, the above ligand of the formula (B-1) can be prepared by the reaction scheme below :

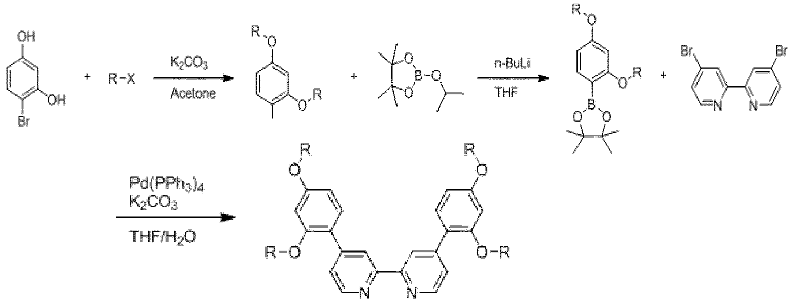

In said reaction scheme, -O-R can be replaced by -S-R or -N-R₂. Also, -O-R group in ortho-position can be replaced by hydrogen, while -O-R, -S-R or -N-R₂ group exists in para-position.

In a more preferred embodiment of the present invention, La in the formula (I) has the formula (B) or the formula (II), in particular the formula (II), and Lb in the formula (I) has the formula (III) below : 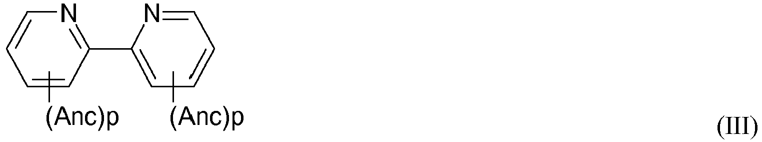 wherein Anc is independently selected from anchoring groups, and p is independently 1, 2, 3 or 4, preferably 1. Preferred examples of the formula (III) are as follows :

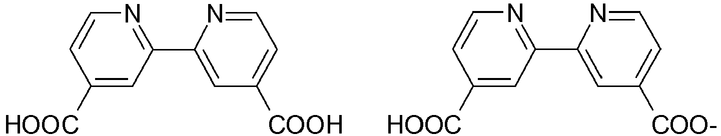

In a still more preferred embodiment of the present invention, the formula (II) can be selected from any one of the structures indicated below, which structures can be further substituted, but not limited to them : 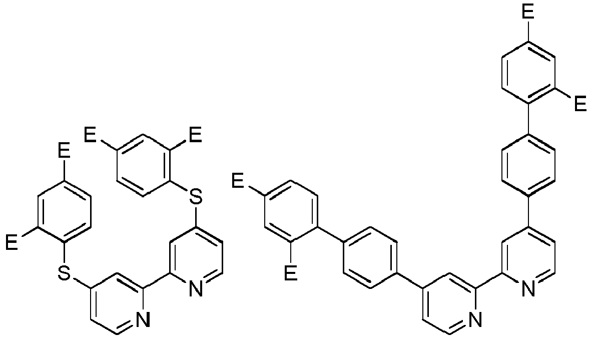 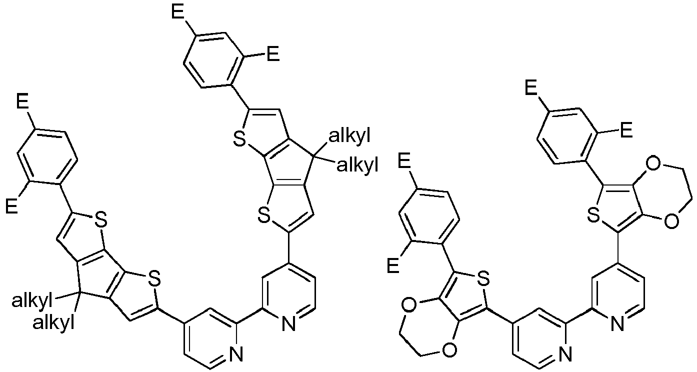 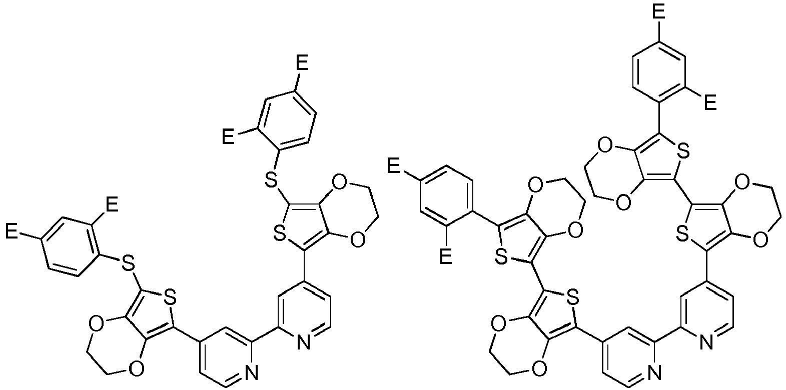 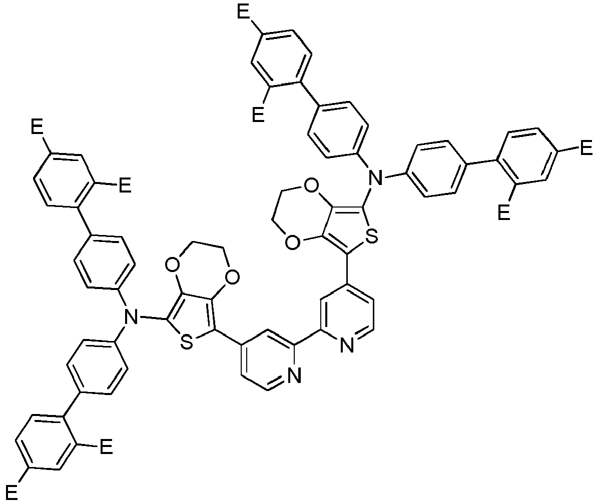 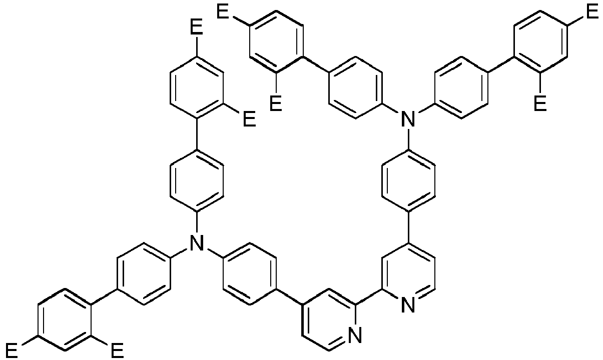 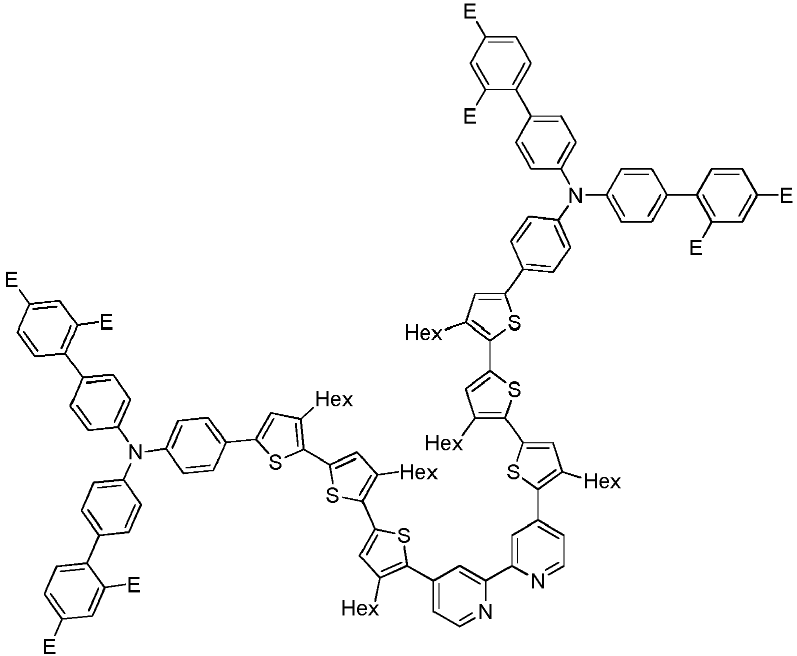 wherein E stands for hydrogen, -OR, -SR or -NR₂ (where R is selected from alkyl groups, preferably butyl, pentyl, hexyl, heptyl, octyl, nonyl or decyl group) provided at least one of E is -OR, -SR or -NR₂, preferably both E are -OR, -SR or -NR₂, or E in ortho-position can be hydrogen while E in para-position is -OR, -SR or -NR₂, and Hex represents hexyl group.

In a yet more preferred embodiment of the present invention, the metal complex suitable for the use as a sensitizing-dye in DSSC has at least one ligand of formula (II-1) below : 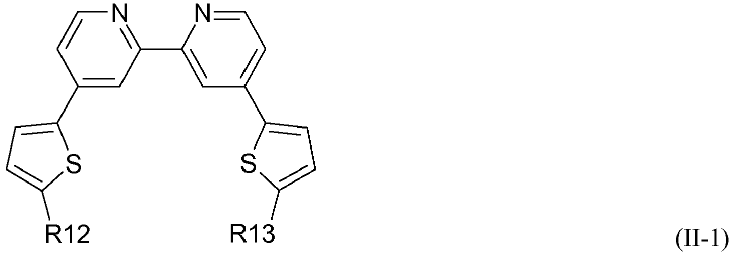 wherein R12 and R13 are independently selected from the group consisting of hydrogen, halogens, cyano, alkyl groups, halogenated alkyl groups, alkoxy groups, halogenated alkoxy groups, aryl groups, halogenated aryl groups, aryloxy groups, halogenated aryloxy groups, heterocycles, halogenated heterocycles, heterocyclic alkyl groups, halogenated heterocyclic alkyl groups, heterocyclic alkoxy groups, halogenated heterocyclic alkoxy groups, heterocyclic aryl groups, halogenated heterocyclic aryl groups, heterocyclic aryloxy groups, halogenated heterocyclic aryloxy groups, amino groups, halogenated amino groups, and NO₂. Preferably, R12 and R13 are alkyl groups, alkoxy groups, aryl groups, or aryloxy groups.

The metal complex according to the present invention most preferably has the formula (I) wherein M is ruthenium, La is the formula (II), Lb is the formula (III), and Lc is the formula (L1), preferably the formula (L1-1).

In a further specific embodiment of the present invention, the metal complex suitable for the use as a sensitizing-dye in DSSC has the formula (I-1) below : 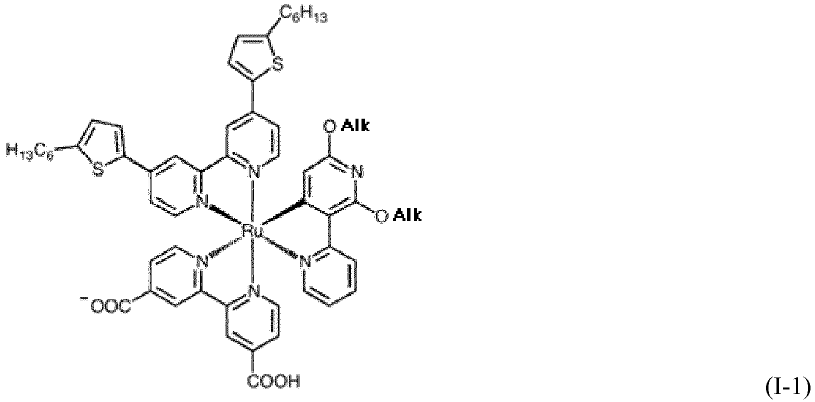 wherein Alk is alkyl groups having 4 or more carbon atoms.

The basic element of a DSSC is generally a semiconductor, such as TiO₂ (titanium dioxide) nanoparticulate structure sensitized with dye molecules to form the core of a DSSC. The assembly of titanium dioxide nanoparticles is well connected to their neighbors. TiO₂ is the preferred material for the nanoparticles since its surface is highly resistant to the continued electron transfer. However, TiO₂ only absorbs a small fraction of the solar photons (those in the UV). The dye molecules attached to the semiconductor surface are used to harvest a great portion of the solar light. Another key component of the DSSC is an electrolyte which transports positive charge carriers from the sensitizing-dye to the back contact of the device. Electrolytes containing the iodide/triiodide redox system are most commonly used. However, the iodide/triiodide redox system suffers from disadvantages, such as low redox potential, corrosive characteristic to metals, and competition with the sensitizing-dye in absorbing light. In this context, the cobalt complex described herein can work in DSSC as redox mediator having improved characteristics, compared to traditional iodide/triiodide redox system. In the present invention, such cobalt complex is used in combination with the metal complex sensitizing-dye described in the present invention without causing a significant decrease in the performance of the system.

The metal complex dye compounds usually consist of one metal atom and organic moiety that provides the required properties (e.g., wide absorption range, fast electron injection, and stability). The dye is sensible to the visible light. The light excites electrons from highest occupied molecular orbitals (HOMO) to lowest unoccupied molecular orbitals (LUMO), which is injected to the semiconductor particles (usually TiO₂). The particulate semiconductor functions as the transporter of light-induced electrons towards the external contact, a transparent conductor that lies at the basis of the semiconductor (usually TiO₂) film.

Construction of a DSSC would be well known by a person skilled in the art. Generally, the DSSC comprises an electrode connected to semiconductor, a counter electrode, and an electrolyte. The electrode connected to semiconductor and the counter electrode are arranged in a sandwich-like configuration, and the electrolyte is inserted between the two electrodes.

The material for the counter electrode is not limited as long as the cathode is formed from a material having conductivity. For a non-limiting example, a substrate comprising electrically conductive transparent glass which contains a small amount of platinum or conductive carbon adhering to the surface can be suitably used. As the electrically conductive transparent glass, a glass made of tin oxide or indium-tin oxide (ITO) can be used.

The electrode connected to semiconductor has a substrate made of electrically conductive transparent glass and a semiconducting layer comprising a semiconductor and the sensitizing-dye compound described in the present invention adsorbed thereto. As an example of the electrically conductive transparent glass for such electrode, a glass comprising the materials described above for the cathode can be used, but not limited to them.

As non-limiting examples of materials for the semiconductor, metal oxides such as titanium oxides, niobium oxides, zinc oxides, tin oxides, tungsten oxides, and indium oxides, preferably TiO₂ and SnO₂ are included. TiOF₂ (titanyl oxyfluoride, titanium oxyfluoride or titanium fluoride oxide) can also be envisaged as a suitable semiconductor. TiOF₂ might be suitable when combined with sensitizing-dyes and/or cobalt complex redox mediator of the present invention. The materials may be used as the sole semiconductor in the DSSC semiconductor layer or may be combined in mixture with any other suitable semiconductor layer material such as gallium oxide etc.

In one aspect of the manufacture of the DSSC, the metal complex dye compound of the present invention is usually caused to be adsorbed on the semiconductor. The dye can be adsorbed, for example, by causing the electrode connected to semiconductor comprising substrate of electrically conductive transparent glass and a semiconducting layer formed on the surface to come in contact with a dye solution containing the sensitizing-dye compound of the present invention and a solvent. The association of the sensitizing-dye compound and the semiconductor can be maintained through chemical bond or electrostatic interaction achieved between the anchoring group of the sensitizing-dye compound and the semiconductor material. Other methods than the adsorption for achieving association of the dye and the semiconductor would be known to a person skilled in the art.

As the electrolyte, a liquid electrolyte, a solid electrolyte, or a solution containing the electrolyte can be used. In the sense of the present invention, the electrolyte is preferably a redox electrolyte, containing a substance forming a redox system, for example a solution containing the cobalt complex described herein and/or optional iodine and imidazolium salt of iodide. As the suitable solvent for the solution, an electrochemically inert substance, such as acetonitrile or propionitrile can be used.

The DSSC can be formed, for example, by filling with the electrolytic solution between the two electrodes face to face. The two electrodes can be thus disposed with a desired distance between them by securing them by sandwiching a spacer between them. Nonetheless, other methods of manufacturing the DSSC would be well understood by a person skilled in the art.

The present invention also concerns a metal complex having the formula (I) :

MLaLbLc (I)

wherein M represents a metal belonging to Group 6, 8, 9, 10 or 11 of the long-format Periodic Table, preferably ruthenium; La and Lb are independently selected from bipyridine ligands, in which at least one of La and Lb correspond to the formula (B) or the formula (II) below : 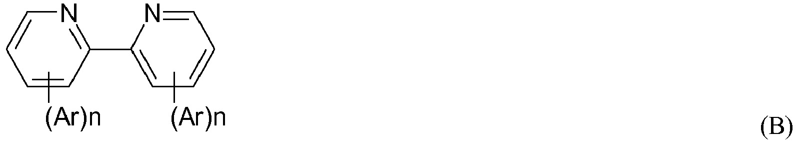 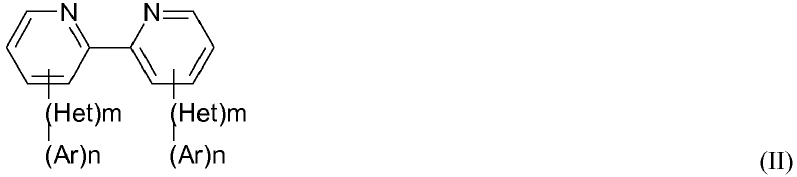 wherein Het is independently selected from a bridge selected from the group consisting of aromatic amine groups, heteroatoms, alkenyl groups, aryl groups, and heterocycles, in particular thiophene, oligothiophenes, ethylenedioxythiophenes (EDOT), oligo-EDOTs, cyclopentanedithiophenes (CPDT), and any combination thereof, preferably sulfur and thiophene, Ar is independently selected from the group consisting of hydrogen, halogens, cyano, alkyl groups, halogenated alkyl groups, alkoxy groups, halogenated alkoxy groups, aryl groups, halogenated aryl groups, aryloxy groups, halogenated aryloxy groups, amino groups, halogenated amino groups, and NO₂, m is independently 1, 2, 3, or 4, and n is 1, 2, 3, or 4; and
Lc is a ligand comprising a moiety selected from the group consisting of formulae (L1), (L2) and (L3) below and at least one substituent having 4 or more carbon atoms : 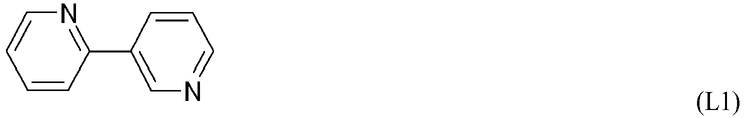 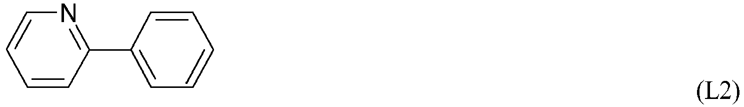 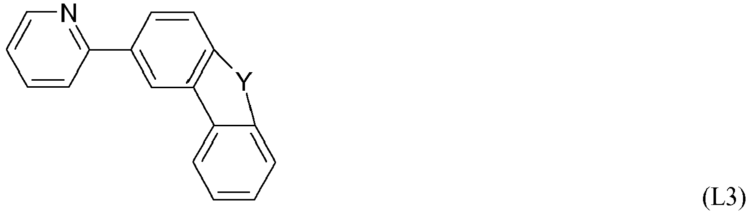 wherein Y is selected from the group consisting of C, N, O, P, P(O), S, Se, B and S(O₂).

Preferably, a metal complex according to the present invention has Lc has a structure selected from the group consisting of the formulae (L1-1), (L2-1), (L2-2), (L2-3), (L2-4), (L2-5), (L3-1), (L3-2), (L3-3) and (L3-4) : 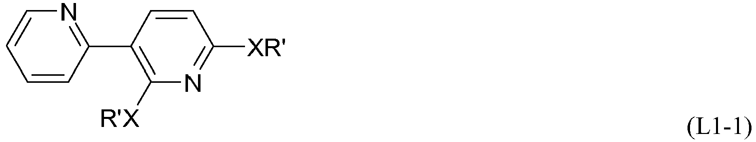 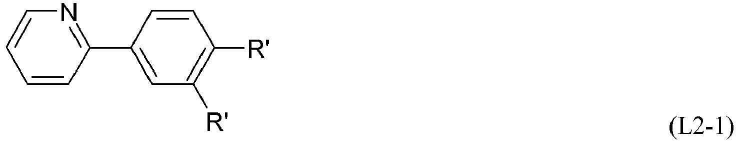 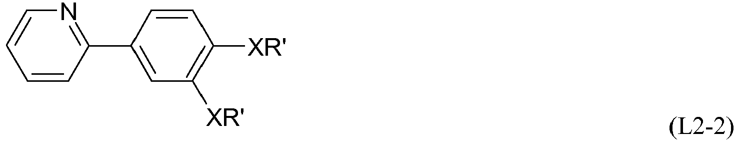 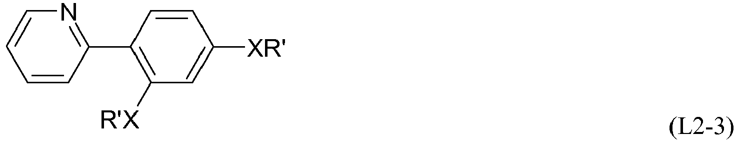 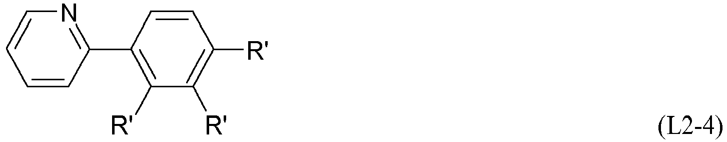 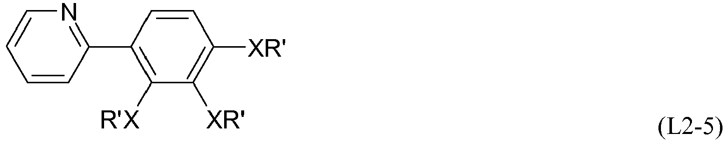 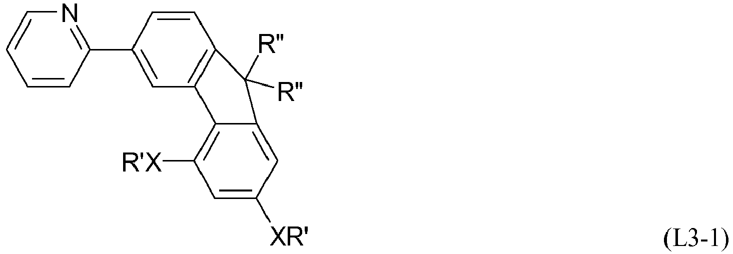 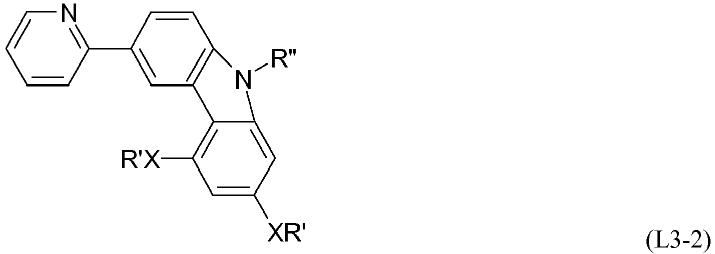 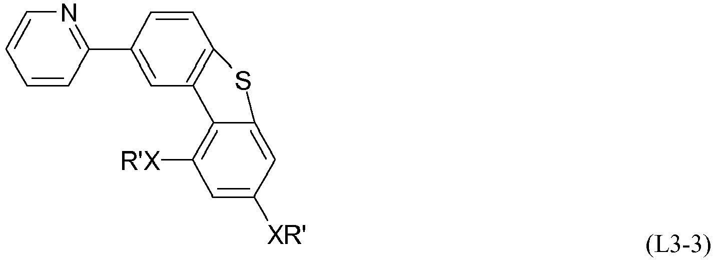 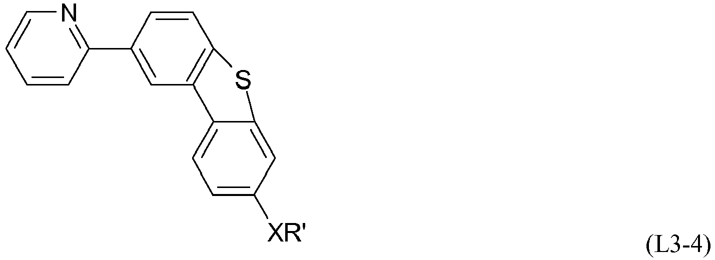 wherein X is independently selected from the group consisting of NR', O and S, preferably X is O, R' is independently selected from the group consisting of alkyl groups, halogenated alkyl groups, aryl groups, halogenated aryl groups, and any derivatives of the foregoing groups wherein at least one of the carbon atom in the foregoing group is replaced by heteroatom, such as N, O and S, preferably by N or O, and any combination thereof, and R" is independently selected from the group consisting of hydrogen, alkyl groups, halogenated alkyl groups, aryl groups, halogenated aryl groups, and any derivatives of the foregoing groups wherein at least one of the carbon atom in the foregoing group is replaced by heteroatom, such as N, O and S, preferably by N or O, and any combination thereof, provided at least one R' comprises 4 or more carbon atoms.

Preferably, the formula (B) has the formula (B-1), (B-2), (B-3), (B-4), (B-5) or (B-6) below : 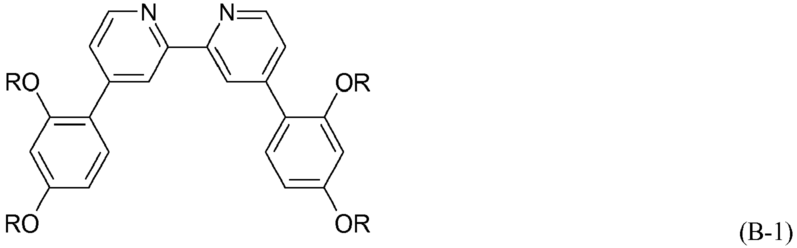 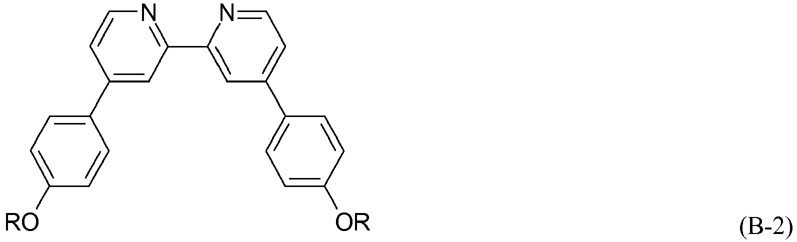 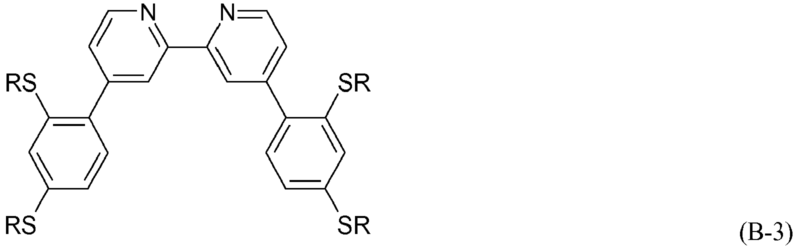 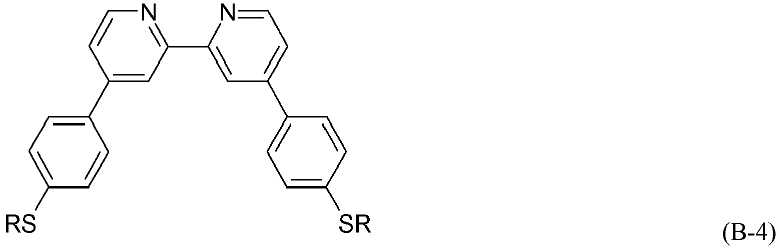 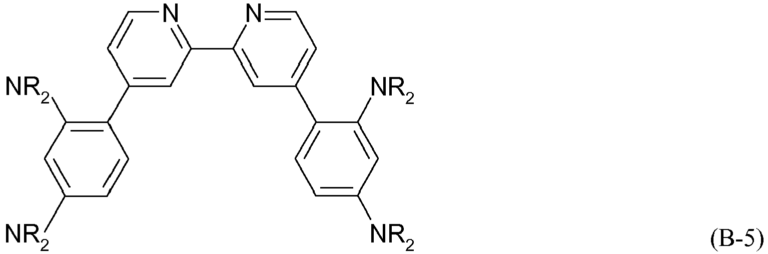 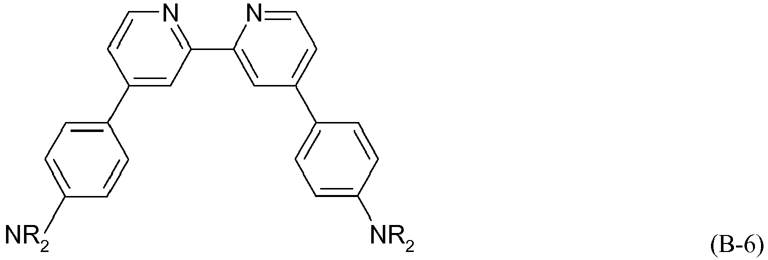 wherein R is selected from alkyl groups, preferably butyl, pentyl, hexyl, heptyl octyl, nonyl or decyl group, especially hexyl group.

More preferably, La in the formula (I) has the formula (B) or the formula (II), in particular the formula (II), and Lb in the formula (I) has the formula (III) below : 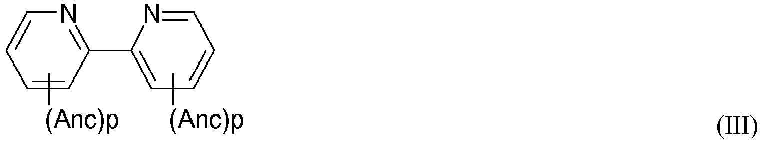 wherein Anc is independently selected from anchoring groups, and p is independently 1, 2, 3 or 4, preferably 1. Preferred examples of the formula (III) are as follows :

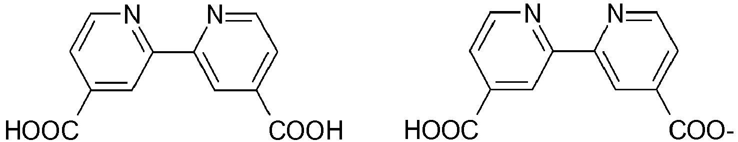

Still more preferably, the formula (II) can be preferably selected from any one of the structures indicated below, which structures can be further substituted, but not limited to them : 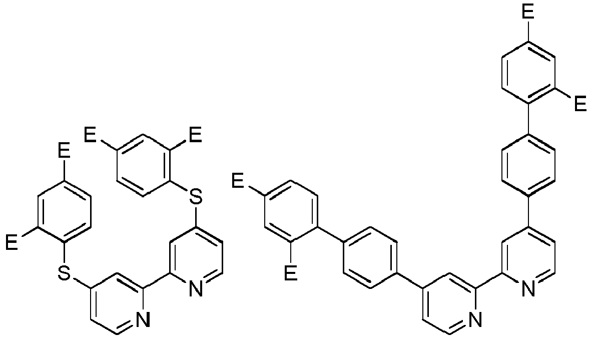 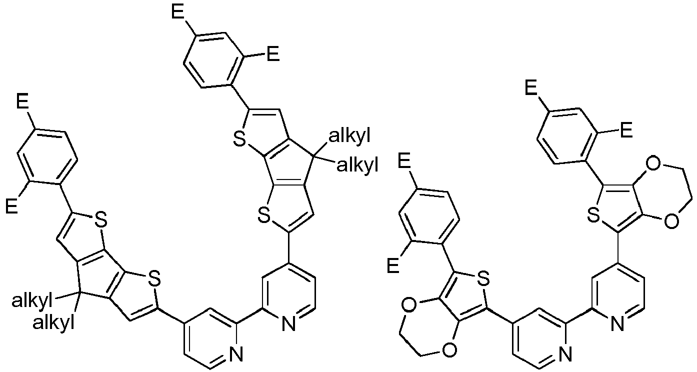 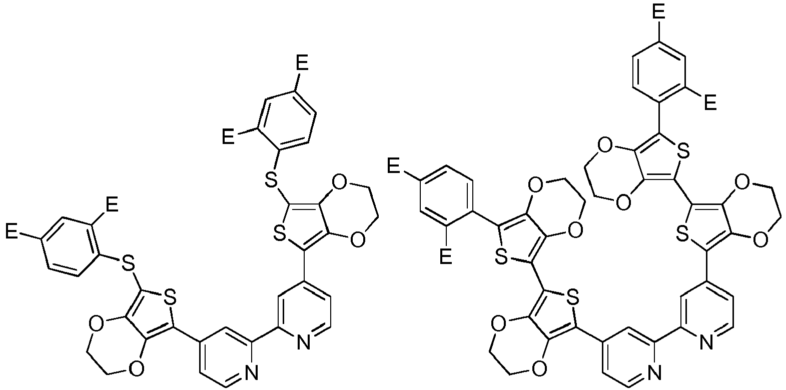 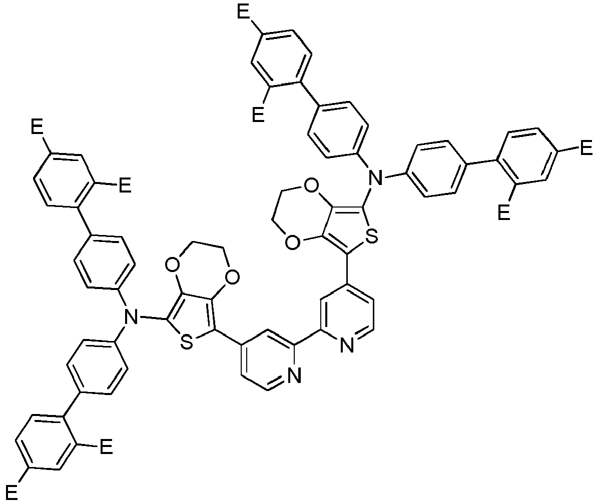 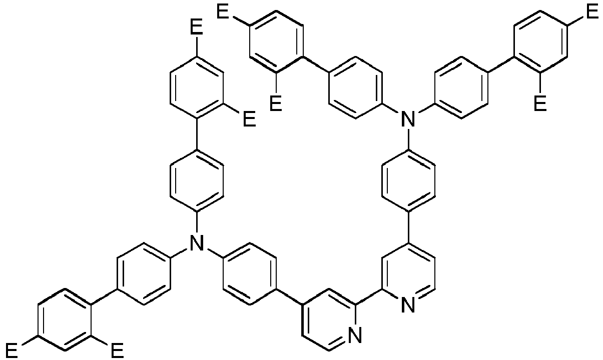 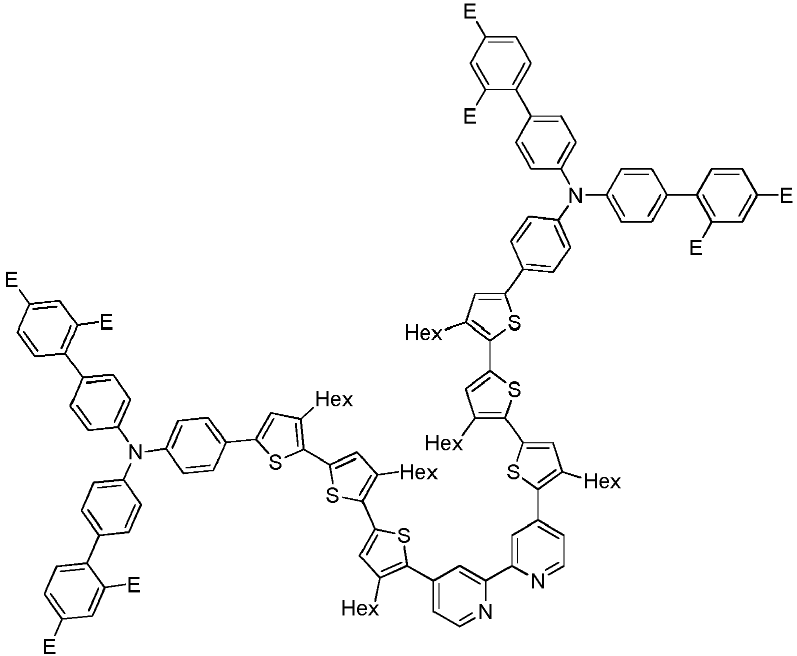 wherein E stands for hydrogen, -OR, -SR or -NR₂ (where R is selected from alkyl groups, preferably butyl, pentyl, hexyl, heptyl, octyl, nonyl or decyl group) provided at least one of E is -OR, -SR or -NR₂, preferably both E are -OR, -SR or -NR₂, or E in ortho-position can be hydrogen while E in para-position is -OR, -SR or -NR₂, and Hex represents hexyl group.

Yet more preferably, the metal complex according to the present invention has at least one ligand of formula (II-1) below as La or Lb in addition to Lc being a ligand comprising a moiety selected from the group consisting of formulae (L1), (L2) and (L3), preferably of formulae (L1-1), (L2-1), (L2-2), (L2-3), (L2-4), (L2-5), (L3-1), (L3-2), (L3-3) and (L3-4) : 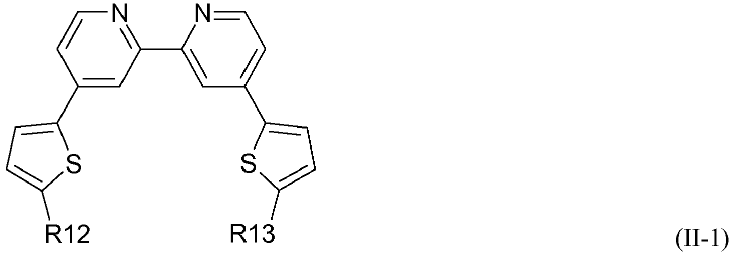 wherein R12 and R13 are independently selected from the group consisting of hydrogen, halogens, cyano, alkyl groups, halogenated alkyl groups, alkoxy groups, halogenated alkoxy groups, aryl groups, halogenated aryl groups, aryloxy groups, halogenated aryloxy groups, heterocycles, halogenated heterocycles, heterocyclic alkyl groups, halogenated heterocyclic alkyl groups, heterocyclic alkoxy groups, halogenated heterocyclic alkoxy groups, heterocyclic aryl groups, halogenated heterocyclic aryl groups, heterocyclic aryloxy groups, halogenated heterocyclic aryloxy groups, amino groups, halogenated amino groups, and NO₂. Preferably, R12 and R13 are alkyl groups, alkoxy groups, aryl groups, or aryloxy groups.

Most preferably, the metal complex according to the present invention has the formula (I-1) below : 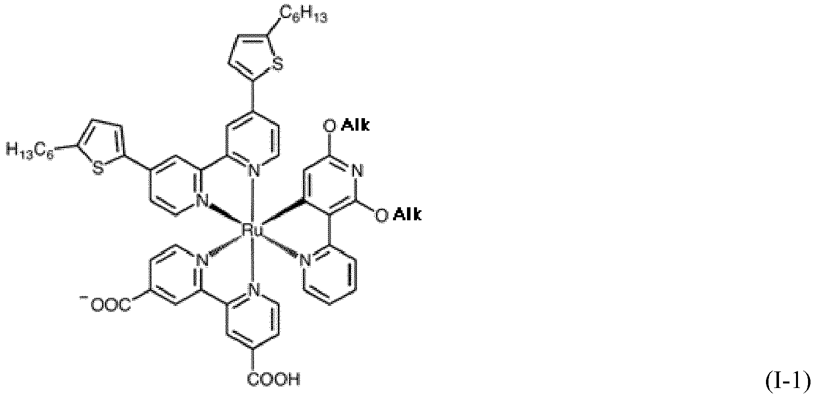 wherein Alk is alkyl groups having 4 or more carbon atoms.

Further aspect of the present invention is related to ligands having a structure selected from the group consisting of the formulae (L1-1), (L2-1), (L2-2), (L2-3), (L2-4), (L2-5), (L3-1), (L3-2), (L3-3) and (L3-4) : 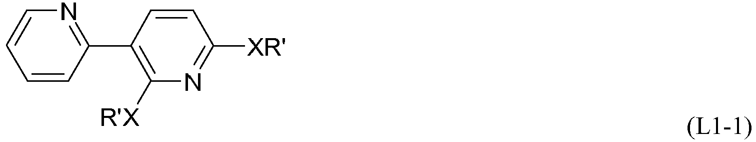 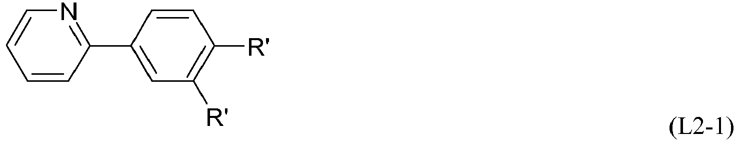 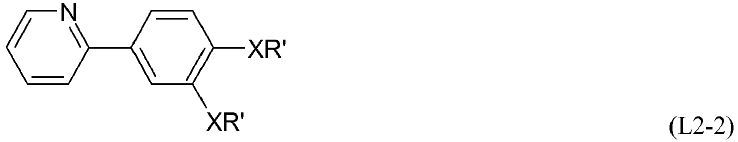 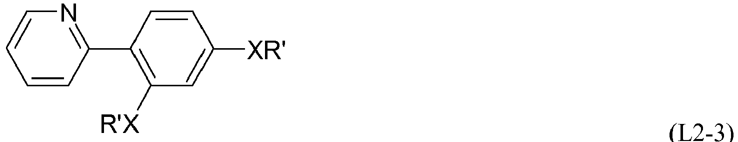 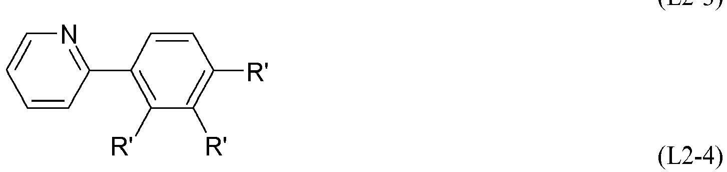 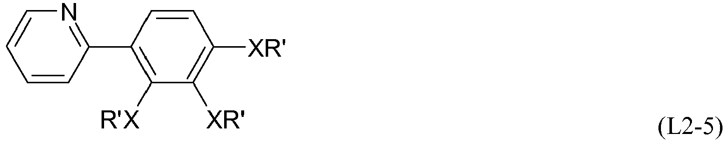 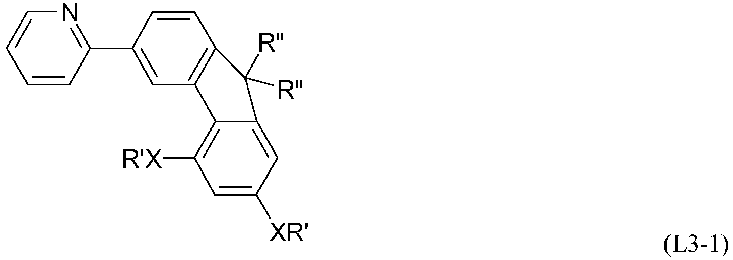 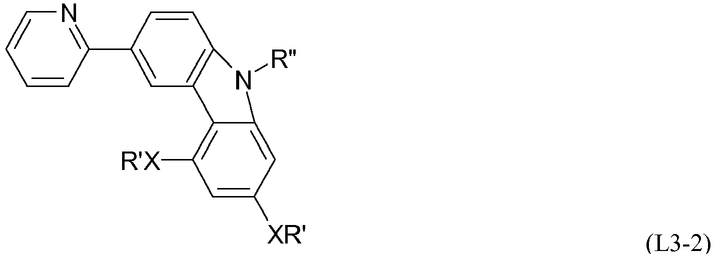 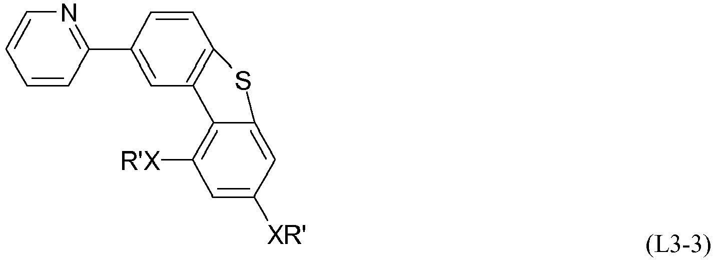 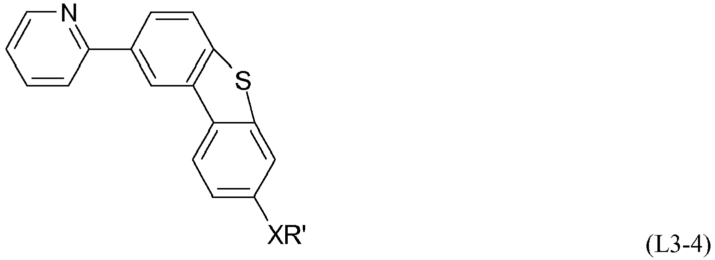 wherein X is independently selected from the group consisting of NR', O and S, preferably X is O, R' is independently selected from the group consisting of alkyl groups, halogenated alkyl groups, aryl groups, halogenated aryl groups, and any derivatives of the foregoing groups wherein at least one of the carbon atom in the foregoing group is replaced by heteroatom, such as N, O and S, preferably by N or O, and any combination thereof, and R" is independently selected from the group consisting of hydrogen, alkyl groups, halogenated alkyl groups, aryl groups, halogenated aryl groups, and any derivatives of the foregoing groups wherein at least one of the carbon atom in the foregoing group is replaced by heteroatom, such as N, O and S, preferably by N or O, provided at least one R' comprises 4 or more carbon atoms.

While preferred embodiments of this invention have been shown and described, modifications thereof can be made by one skilled in the art without departing from the spirit or teaching of this invention. The embodiments and examples described herein are exemplary only and are not limiting. Many variations and modifications of systems and methods are possible and are within the scope of the invention. Accordingly, the scope of protection is not limited to the embodiments described herein, but is only limited by the claims that follow, the scope of which shall include all equivalents of the subject matter of the claims.

### Examples

### Example 1 : Synthesis of metal complex of the formula (I-1) in which Alk is dodecyl

### Example 1-1 : Synthesis of 2',6'-Bis(dodeeyloxy)-2,3'-bipyridine ligand

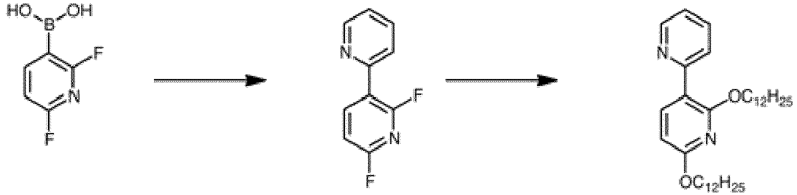

A flask was charged with (2,6-difluoropyridin-3-yl)boronic acid (96 %, 1.00 g, 6.04 mmol), 2-bromopyridine (99 %, 0.980 g, 6.04 mmol, 1.0 equiv.) and Pd(PPh₃)₄ (97 %, 0.360 g, 0.302 mmol, 5 mol %). The solids were degassed with nitrogen and dissolved in a 3:7 mixture of 2M aqueous Na₂CO₃ and THF (9 and 21 mL, respectively). After further degassing, the mixture was warmed to 80°C and refluxed for 18 h under vigorous stirring, then cooled to RT, extracted with CH₂Cl₂, and washed with water. The organic layer was decanted, dried over MgSO₄, filtered and evaporated to dryness. Purification by chromatography, silica prepared in hexane / Et₂O 80:20, isocratic elution with hexane / Et₂O 80:20, afforded the product as a white crystalline solid (0.990 g, 5.15 mmol, 85 %). ¹H NMR (CDCl₃, 400 MHz) : *δ* 8.70 (ddd, J = 4.8, 1.8, 1.2 Hz, 1H), 8.67 (ddd, *J*= 8.0, 6.4, 1.6 Hz, 1H), 7.85 (m, *J*= 8.0, 3.2, 1.2 Hz, 1H), 7.78 (ddd, *J*= 8.2, 6.4, 1.8 Hz, 1H), 7.29 (ddd, *J*= 4.8, 2.6, 1.2 Hz, 1H), 6.96 (ddd, *J*= 8.2, 3.2, 1.6 Hz, 1H).

NaH (twice washed with hexane, 60 % in mineral oil, 2.50 g, 0.062 mol) was added to 1-dodecanol (8.73 g, 0.047 mol) in anhydrous 1,4-dioxane (150 mL) and the resulting solution heated at reflux under an inert atmosphere for 2 h. The solution of alkoxide was cooled to RT and 2',6'-difluoro-2,3'-bipyridine (3.00 g, 0.016 mol) was added portion wise with stirring followed by heating at reflux for 12 h. The reaction mixture was partitioned between hexane (200 mL) and water (500 mL), and the organic layer was further washed with water then brine. The organic portion was dried (Na₂SO₄), filtered and evaporated. The crude product was recrystallized from hexane to afford the desired product (7.77 g, 0.015 mol, 95 %) as a white solid. ¹H NMR (400 MHz, CDCl₃, 25 °C) : δ = 8.64 (ddd, ³J = 4.9 Hz, ⁴J = 1.9 Hz, ⁵J = 0.9 Hz, 1H), 8.30 (d, J = 8.3 Hz, 1H), 8.03 (d, ³J = 8.1 Hz, 1H), 7.69 (ddd, ³J = 8.1, 7.5 Hz, ⁴J = 1.9 Hz, 1H), 7.13 (ddd, ³J = 7.5, 4.9 Hz, ⁴J = 0.9 Hz, 1H), 6.44 (d, J = 8.3 Hz, 1H), 4.40 (t, J = 6.8 Hz, 2H), 4.30 (t, J = 6.8 Hz, 2H), 1.75-1.84 (m, 4H), 1.43-1.45 (m, 4H), 1.24-1.37 (m, 32H), 0.88 (t, J = 6.8 Hz, 6H). ¹³C{¹H} NMR (100 MHz, CDCl₃, 25 °C) : δ = 162.8, 159.6, 154.5, 149.2, 142.1, 135.7, 123.9, 121.0, 113.9, 102.0, 66.4, 66.2, 31.9, 29.68, 29.65, 29.62, 29.60, 29.47, 29.40, 29.36, 29.14, 29.09, 26.2, 26.1, 22.7, 14.1. HRMS (ESI) : m/z = 525.4413 [M+H]⁺, (calcd for [C₃₄H₅₇N₂O₂]⁺ : m/z = 525.4415.

### Example 1-2 : Synthesis of 4,4'-Bis(5-hexylthiophen-2-yl)-2,2'-bipyridine ligand

To a degassed toluene/H₂O solution (3:1 *vlv*; 28 mL) containing 2-(5-hexylthiophen-2-yl)-4,4,5,5-tetramethyl-1,3,2-dioxaborolane (3.00 g, 10.2 mmol), 4,4'-dibromo-2,2'-bipyridine (1.28 g, 4.08 mmol) and K₂CO₃ (1.94 g, 14.0 mmol) was added Pd(PPh₃)₄ (0.100 g, 0.080 mmol). The reaction was heated at reflux for 40 h, cooled and then extracted with CH₂Cl₂ (3 × 30 mL). The organic fractions were combined, dried over MgSO₄ and filtered. The crude product obtained after solvent removal was purified using a SiO₂ plug, eluting with CH₂Cl₂ followed by EtOAc, to yield an off-white solid (0.768 g, 1.57 mmol, 46 %). ¹H NMR (400 MHz, CD₂Cl₂, 25 °C) : *δ* = 8.63 (d, *J* = 5.4 Hz, 2H), 8.60 (s, 2H), 7.49 (d, *J* = 3.0 Hz, 2H), 7.45 (d, *J* = 4.8 Hz, 2H), 6.82 (d, *J*= 3.0 Hz, 2H), 2.85 (t, *J*= 5.0 Hz, 4H), 1.74-1.69 (m, 4H), 1.41-1.32 (m, 12H), 0.90 (t, *J* = 6.6 Hz, 6H). MS (EI) : *m*/*z* = 488 [M]⁺ (calcd for [C₃₀H₃₆N₂O₂]⁺ : *m*/*z* = 488.75).

### Example 1-3 : Synthesis of metal complex of the formula (I-1) in which Alk is dodecyl

To an oven-dried flask containing [Ru(C₆H₆)Cl₂]₂ (0.500 g, 1.00 mmol), NaOH (0.082 g, 2.05 mmol), KPF₆ (0.736 g, 4.00 mmol), and 2',6'-Bis(dodecyloxy)-2,3'-bipyridine (1.08 g, 2.05 mmol) was added anhydrous acetonitrile (0.05 M) under nitrogen atmosphere. The reaction was heated at 45°C for 75 h. The reaction mixture was filtered while hot and the filtrate was concentrated under reduced pressure. The crude mixture was passed through a column of basic Al₂O₃ eluting with a gradient of 0-50 % acetonitrile in dichloromethane to collect the product as a yellow solid (0.799 g, 0.855 mmol, 43 %) from the first yellow band. ¹H NMR (400 MHz, CD₃CN, 25 °C) : *δ* = 8.88 (d, *J*= 5.7 Hz, 1H), 8.43 (d, *J*= 8.3 Hz, 1H), 7.69 (ddd, *³J* = 8.3, 7.6 Hz, *⁴J* = 1. 7 Hz, 1H), 7.05 (ddd, *³J* = 7.2, 5.7 Hz, *⁴J* = 1. 7 Hz, 1H), 6.94 (s, 1H), 4.46 (t, *J*= 6.6 Hz, 2H), 4.31 (t, *J*= 6.8 Hz, 2H), 2.50 (s, 3H), 2.02 (s, 6H), 1.94 (s, 3H), 1.88 (quint., *J*= 7.4 Hz, 2H), 1.77 (quint., *J*= 7.4 Hz, 2H), 1.60-1.20 (m, 36H), 0.88 (t, *J*= 6.8 Hz, 6H). HRMS (ESI) : *m*/*z* = 789.4381 [M]⁺, 748.4530 [M-CH₃CN]⁺ (calcd for [RuC₄₂H₆₇N₆O₂]⁺ : *m*/*z* = 789.4369, [RuC₄₀H₆₄N₅O₂]⁺ : *m*/*z* = 748.4104). Anal. calcd. for RuC₄ₒH₆₄N₅O₂PF₆ : C, 53.80; H, 7.22; N, 7.84. Found : C, 53.72; H, 7.21; N, 8.24.

A 0.01 M solution of 4,4'-Bis(5-hexylthiophen-2-yl)-2,2'-bipyridine (0.131 g, 0.270 mmol) and 4,4'-dimethylester-2,2'-bipyridine (0.073 g, 0.270 mmol) in absolute ethanol was heated at 70°C until both ligands dissolved. The obtained product by collecting the first yellow band above (0.250 g, 0270 mmol) was added to the solution and the reaction mixture was heated at reflux for 0.5-1 h. Upon cooling the mixture and removing the solvent under reduced pressure, the crude product was purified by column chromatography (SiO₂), eluting with a gradient of 2-10 % acetonitrile in dichloromethane, to yield three bands corresponding to the bis-heteroleptic complex containing two 4,4'-Bis(5-hexylthiophen-2-yl)-2,2'-bipyridine ligands, the tris-heteroleptic complex containing a 4,4'-Bis(5-hexylthiophen-2-yl)-2,2'-bipyridine ligand, a 4,4'-dimethylester-2,2'-bipyridine ligand and a 2',6'-Bis(dodecyloxy)-2,3'-bipyridine ligand as the product being a dark solid (0.183 g, 0.120 mmol, 45 %), and the bis-heteroleptic complex containing two 4,4'-dimethylester-2,2'-bipyridine ligands (listed in order of increasing polarity). ¹H NMR (400 MHz, CDCl₃, 25 °C) : *δ* = 8.90 (br. s, 1H, H₁₃), 8.80 (d, *J*= 1.6 Hz, 1H, H_{13'}), 8.55 (d, *J*= 8.4 Hz, 1H, H₄), 8.38 (d, *J*= 6.0 Hz, 1H, H₁₁), 8.19 (d, *J*= 1.8 Hz, 1H, H_{8'}), 8.17 (d, *J*= 1.8 Hz, 1H, H₈), 8.12 (d, *J*= 5.6 Hz, 1H, H11_{'}), 8.02 (dd, *J*= 5.8, 1.0 Hz, H₁₂), 7.66 (dd, *J*= 5.6, 1.2 Hz, H_{12'}), 7.56 (ddd, *J*= 8.7, 7.0, 1.7 Hz, 1H, H₃), 7.53-7.48 (m, 2H, H_{6'} + H_{9'}), 7.47 (d, *J*= 3.6 Hz, 1H, H₉), 7.38-7.33 (m, 2H, H₁ + H_{7'}), 7.31 (d, *J*= 6.0 Hz, 1H, H₆), 7.23 (dd, *J*= 5.6, 1.6 Hz, H₇), 6.86-6.76 (m, 3H, H₁₀ + H_{10'} + H₂), 5.56 (s, 1H, H₅), 4.45 (m, 2H), 4.13 (m, 2H), 4.02 (s, 3H), 4.01 (s, 3H), 2.84 (m, 4H), 1.90 (quint., *J*= 7.2 Hz, 2H), 1.70 (m, 6H), 1.52 (quint., *J* = 7.6 Hz, 2H), 1.45-1.17 (m, 46H), 0.94-0.86 (m, 12H). HRMS (ESI) : *m*/*z* = 1385.6445 [M]⁺ (calcd for [RuC₇₈H₁₀₃N₆O₆S₂]⁺ : *m*/*z* = 1385.6424). Anal. calcd. for RuC₇₈H₁₀₃N₆O₆S₂PF₆ : C, 61.20; H, 6.78; N, 5.49. Found : C, 61.13; H, 6.80; N, 5.33.

A DMF/H₂O/NEt₃ solution (3:1:1 *vlvlv*; 0.01 M) containing the appropriate tris-heteroleptic complex was heated at reflux. After 16 h, the solvent was removed under reduced pressure. The product was recrystallized from dichloromethane and hexane to yield the product as a dark solid (0.093 g, 0.062 mmol, 95 %). ¹H NMR (400 MHz, CDCl₃, 25 °C) : *δ* = 10.07 (br. s, 1H; H₁₃), 9.94 (br. s, 1H; H_{13'}), 8.56 (d, *J* = 8.4 Hz, 1H, H₄), 8.17 (d, *J*= 6.0 Hz, 1H, H₁₁), 8.13 (br. s, 1H, H_{8'}), 8.10 (br. s, 1H, H₈), 7.99 (d, *J* = 5.6 Hz, 1H, H₁₂), 7.79 (d, *J*= 5.6 Hz, H_{12'}), 7.70 (d, *J*= 5.6 Hz, H_{11'}), 7.58-7.49 (m, 2H, H₃ + H_{6'}), 7.47 (d, *J* = 6.1 Hz, 1H, H₆), 7.40 (d, *J* = 3.6 Hz, 1H, H_{9'}), 7.37 (d, *J* = 3.6 Hz, 1H, H₉), 7.34 (d, *J*= 5.6 Hz, 1H, H₁), 7.27-7.23 (m, 1H, H_{7'}), 7.21 (dd, *J*= 6.1, 2.0 Hz, 1H, H₇), 6.83 (d, *J*= 3.7 Hz, 1H, H_{10'}), 6.81 (d, *J*= 3.7 Hz, 1H, H₁₀), 6.71 (ddd, *J*= 7.5, 5.6, 1.7 Hz, 1H, H₂), 5.60 (s, 1H, H₅), 4.44 (m, 2H), 4.12 (m, 2H), 2.83 (m, 4H), 1.89 (quint., *J*= 7.2 Hz, 2H), 1.78-1.59 (m, 6H), 1.51 (quint., *J*= 7.4 Hz, 2H), 1.43-1.15 (m, 46H), 0.91-0.80 (m, 12H). HRMS (ESI) *: m*/*z* = 1357.6132 [M+H]⁺ (calcd for [RuC₇₆H₉₉N₆O₆S₂]⁺ : *m*/*z* = 1357.6116).

### Example 2 : Solar cell fabrication and characterization

The TiO₂ films used in this example consist of a 4.0 m TiO₂ mesoporous layer (particle size : 20 nm; pore size : 32 nm) and a 4.0 m TiO₂ scattering layer (particle size : 400 nm). The dye obtained in Example 1 was tested as photosensitizer for DSSC devices. The working electrode was prepared by immersing the 8.0 m thick TiO₂ film into a solution of the corresponding dye in tetrahydrofuran / ethanol solution (1:4 ratio, 0.2 mM) with 2 equivalents of chenodeoxycholic acid (CDCA) for 6 hours. Thermally platinized FTO was used as counter electrode. The working and counter electrodes were sealed with a 15 m thick hot-melt film (Surlyn, Solaronix) by heating the system at 120°C. Devices were completed by filling the electrolyte through pre-drilled holes in the counter electrodes. Finally, the holes were sealed with another Surlyn sheet and a thin glass cover by heating. An antireflective film was adhered to the cell during the measurements. A black mask (0.159 mm²) that is smaller than the active area of the cells was used in subsequent photovoltaic studies.

### Example 3 : Evaluation of Dye-Sensitized Solar Cells

For photovoltaic measurements of the DSSCs, the irradiation source was a 450 W xenon light source (Osram XBO 450) with a filter (Schott 113), whose power was regulated to the AM 1.5G solar standard by using a reference Si photodiode equipped with a colour-matched filter (KG-3, Schott) to reduce the mismatch in the region of 350-750 nm between the simulated light and AM 1.5G to less than 4 %. The measurement-settling time between applying a voltage and measuring a current for the *J-V* characterization of DSSCs was fixed to 80 ms. The incident photon to collected electron conversion efficiency (IPCE) measurement was plotted as function of wavelength by using the light from a 300-W xenon lamp (ILC Technology), which was focused through a Gemini-180 double monochromator (Jobin Yvon) onto the photovoltaic cell under test. A computer-controlled monochromator was incremented through the spectral range (300-900 nm) to generate a photocurrent action spectrum with a sampling interval of 10nm and a current sampling time of 4s. To reduce scattered light from the edge of the glass electrodes of the dyed TiO₂ layer, a light-shading mask was used on the DSSCs, so the active area of DSSCs was fixed to 0.2 cm².

**Table 1 : IPCE measurements for the metal complex according to Example 1**

| Dye | Electrolyte | Jsc (mA/cm²) | Voc (mV) | Fill Factor | H (%) |
|---|---|---|---|---|---|
| Example 1 | Iodine | 16.3 | 715 | 0.75 | 8.7 |
| Example 1 | Cobalt complex ([Co^{II/III}(phen)₃]^{2/3+}) | 13.2 | 837 | 0.78 | 8.6 |

## Claims

1. A dye-sensitized solar cell, comprising a metal complex and a cobalt mediator wherein said metal complex comprises at least one bidentate ligand comprising a first aromatic ring comprising at least one nitrogen atom as ring atom and a second aromatic ring connected to the first aromatic ring, said bidentate ligand being substituted by at least one substituent having 4 or more carbon atoms, wherein the first aromatic ring is coordinated to the metal through a metal-nitrogen bond and the second aromatic ring is coordinated to the metal through a metal-carbon bond.

2. The dye-sensitized solar cells according to claim 1, wherein the bidentate ligand comprises a moiety selected from the group consisting of formulae (L1), (L2) and (L3) : 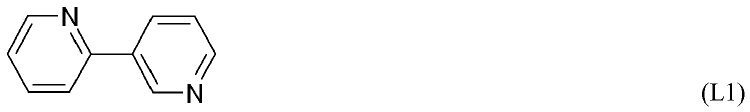 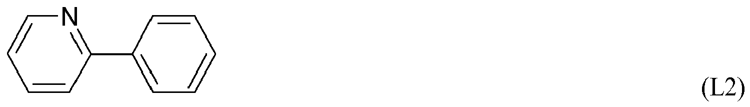 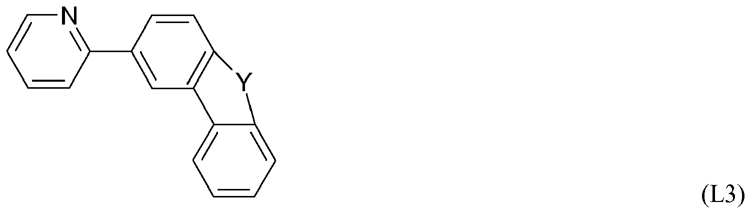 wherein Y is selected from the group consisting of C, N, O, P, P(O), S, Se, B and S(O₂).

3. The dye-sensitized solar cell according to claim 1 or 2, wherein the bidentate ligand has a structure selected from the group consisting of the formulae (L1-1), (L2-1), (L2-2), (L2-3), (L2-4), (L2-5), (L3-1), (L3-2), (L3-3) and (L3-4) : 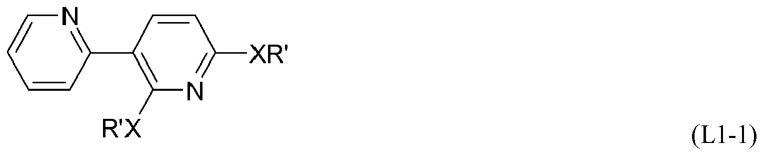 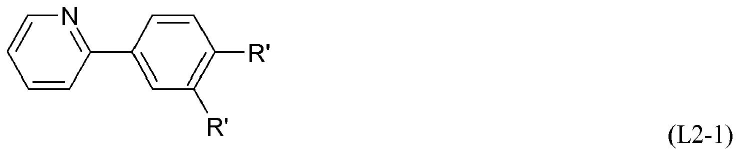 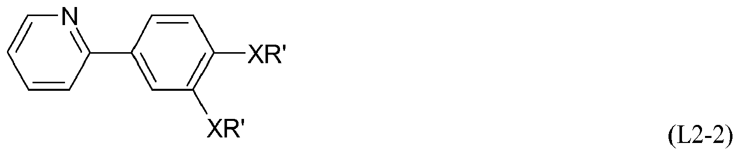 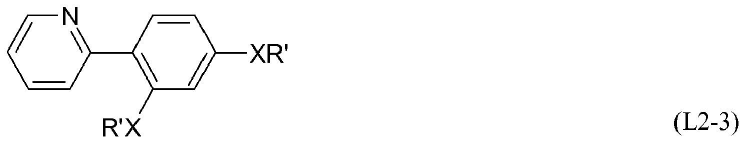 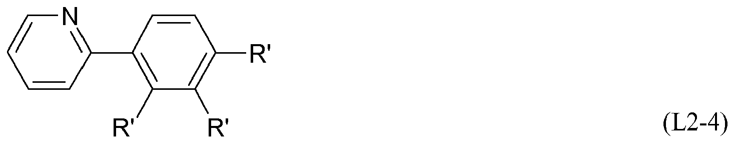 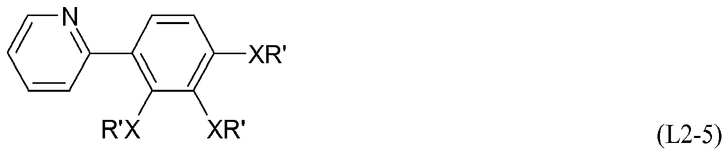 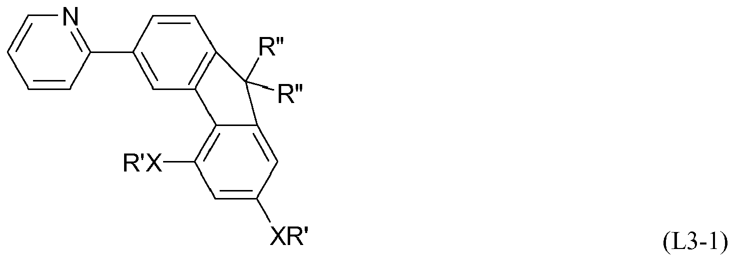 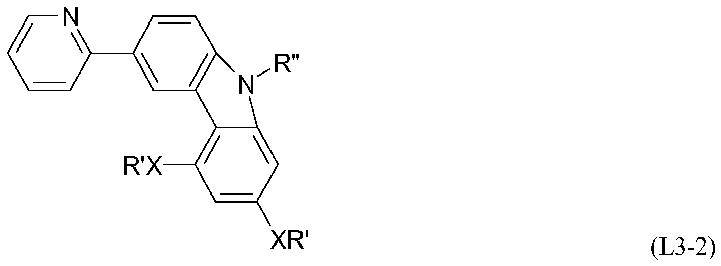 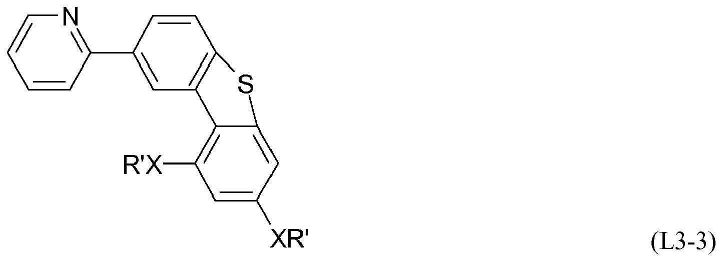 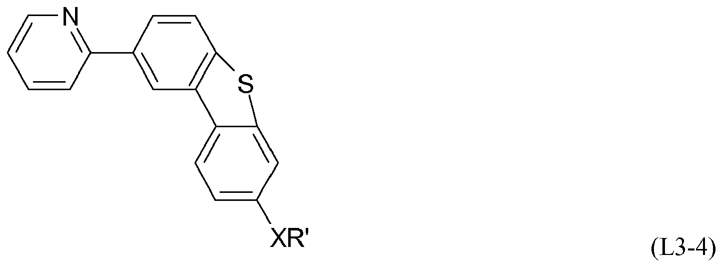 wherein X is independently selected from the group consisting of NR', O and S, R' is independently selected from the group consisting of alkyl groups, halogenated alkyl groups, aryl groups, halogenated aryl groups, and any derivatives of the foregoing groups wherein at least one of the carbon atom in the foregoing group is replaced by N, O and/or S, and any combination thereof, and R" is independently selected from the group consisting of hydrogen, alkyl groups, halogenated alkyl groups, aryl groups, halogenated aryl groups, and any derivatives of the foregoing groups wherein at least one of the carbon atom in the foregoing group is replaced by N, O and/or S, and any combination thereof, provided at least one R' comprises 4 or more carbon atoms.

4. The dye-sensitized solar cell according to any one of claims 1 to 3, wherein the bidentate ligand comprises at least one substituent having 4 to 18 carbon atoms, preferably 6 to 12 carbon atoms.

5. The dye-sensitized solar cell according to any one of claims 1 to 4, wherein the cobalt mediator comprises at least one ligand selected from the group consisting of the following structures. 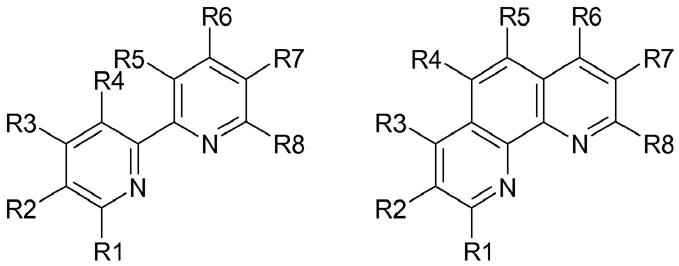 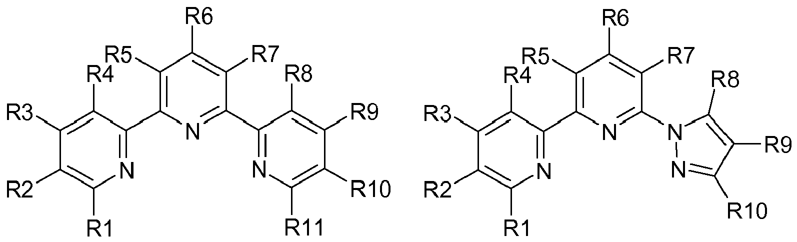 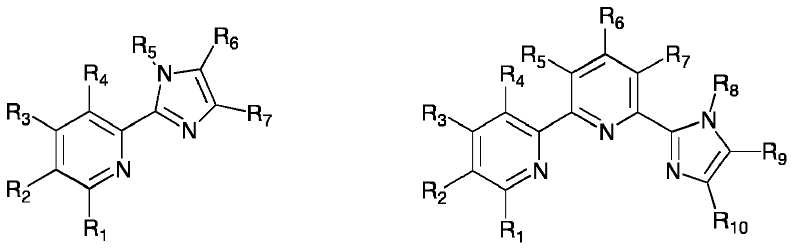 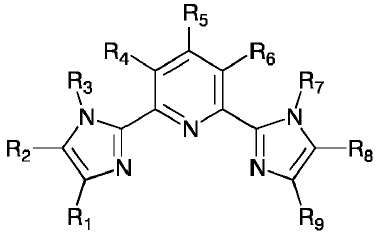 wherein R1, R2, R3, R4, R5, R6, R7, R8, R9, R10 and R11 are independently selected from the group consisting of hydrogen, halogens, in particular fluorine, amino groups, NO₂, CN, alkyl groups, halogenated alkyl groups, aryl groups, halogenated aryl groups, particularly hydrogen, fluorine, alkyl groups, and fluorinated alkyl groups.

6. The dye-sensitized solar cell according to any one of claims 1 to 5,
wherein the metal complex has the formula (I) :
MLaLbLc (I)
wherein M represents a metal belonging to Group 6, 8, 9, 10 or 11 of the long-format Periodic Table, preferably ruthenium ;
La and Lb are independently selected from bipyridine ligands, in which at least one of La and Lb correspond to the formula (B) or the formula (II) below : 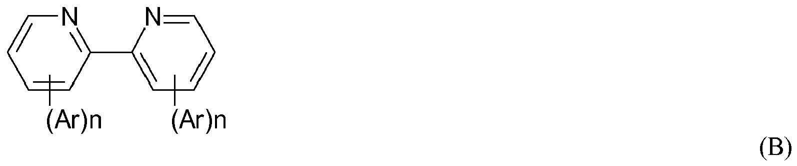 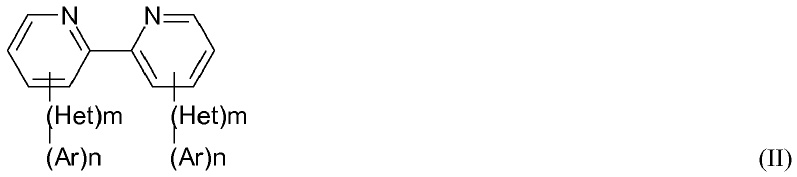 wherein Het is independently selected from a bridge selected from the group consisting of aromatic amine groups, heteroatoms, alkenyl groups, aryl groups, and heterocycles, in particular thiophene, oligothiophenes, ethylenedioxythiophenes (EDOT), oligo-EDOTs, cyclopentanedithiophenes (CPDT), and any combination thereof, preferably sulfur and thiophene, Ar is independently selected from the group consisting of hydrogen, halogens, cyano, alkyl groups, halogenated alkyl groups, alkoxy groups, halogenated alkoxy groups, aryl groups, halogenated aryl groups, aryloxy groups, halogenated aryloxy groups, amino groups, halogenated amino groups, and NO₂, m is independently 1, 2, 3, or 4, and n is 1, 2, 3, or 4; and
Lc is the ligand comprising a moiety selected from the group consisting of formulae (L1), (L2) and (L3).

7. The dye-sensitized solar cell according to claim 6, wherein La has the formula (B) or the formula (II) and Lb has the formula (III) below : 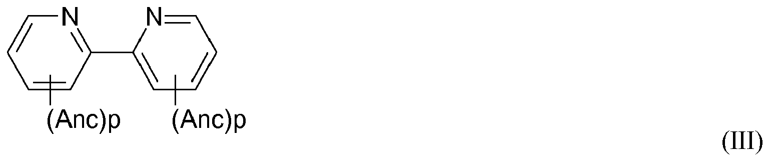 wherein Anc is independently selected from anchoring groups, and p is independently 1, 2, 3 or 4, preferably 1.

8. The dye-sensitized solar cell according to any one of claims 1 to 7, wherein the anchoring group is selected from the group consisting of -COOH, -PO₃H₂, -P(=O)(Ra)(OH) (wherein Ra is selected from the groups consisting of optionally branched C1-C18 alkyl groups and optionally substituted C5-C12 aryl groups, and halogenated derivatives thereof), -PO₄H₂, -PO₂HRb (wherein Rb is selected from alkyl groups or aryl groups), -SO₃H, -CONHOH, -NO₂, acetylacetonate, acrylic acid derivatives, malonic acid derivative, rhodanine-3-acetic acid, propionic acid, deprotonated forms of the aforementioned, salts of said deprotonated forms, and chelating groups with π-conducting character, in particular from the group consisting of -COOH, and salts of the deprotonated forms of the aforementioned.

9. A metal complex having the formula (I) :
MLaLbLc (I)
wherein M represents a metal belonging to Group 6, 8, 9, 10 or 11 of the long-format Periodic Table, preferably ruthenium ;
La and Lb are independently selected from bipyridine ligands, in which at least one of La and Lb correspond to the formula (B) or the formula (II) below : 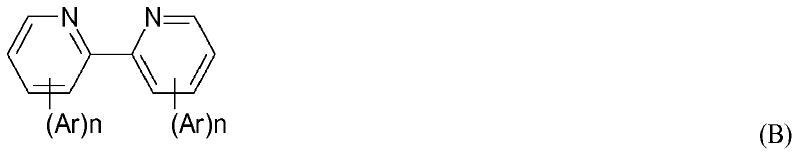 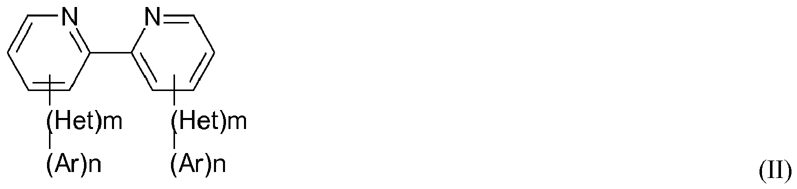 wherein Het is independently selected from a bridge selected from the group consisting of aromatic amine groups, heteroatoms, alkenyl groups, aryl groups, and heterocycles, in particular thiophene, oligothiophenes, ethylenedioxythiophenes (EDOT), oligo-EDOTs, cyclopentanedithiophenes (CPDT), and any combination thereof, preferably sulfur and thiophene, Ar is independently selected from the group consisting of hydrogen, halogens, cyano, alkyl groups, halogenated alkyl groups, alkoxy groups, halogenated alkoxy groups, aryl groups, halogenated aryl groups, aryloxy groups, halogenated aryloxy groups, amino groups, halogenated amino groups, and NO₂, m is independently 1, 2, 3, or 4, and n is 1, 2, 3, or 4; and
Lc is a ligand comprising a moiety selected from the group consisting of formulae (L1), (L2) and (L3) below and at least one substituent having 4 or more carbon atoms : 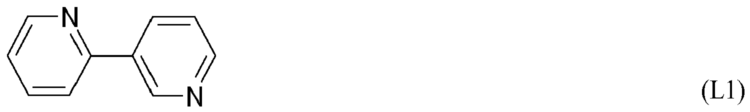 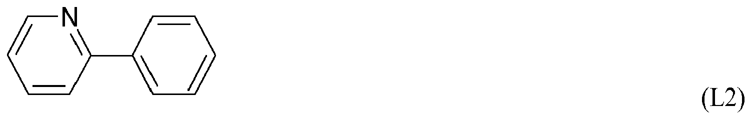 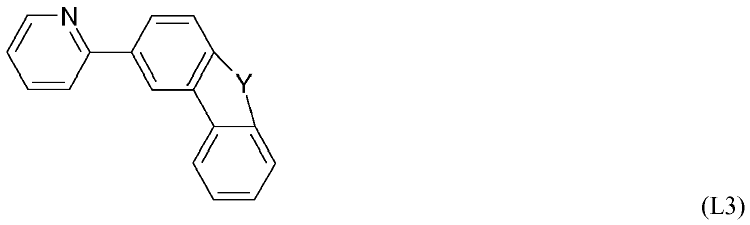 wherein Y is selected from the group consisting of C, N, O, P, P(O), S, Se, B and S(O₂).

10. The metal complex according to claim 9, wherein Lc has a structure selected from the group consisting of the formulae (L1-1), (L2-1), (L2-2), (L2-3), (L2-4), (L2-5), (L3-1), (L3-2), (L3-3) and (L3-4) : 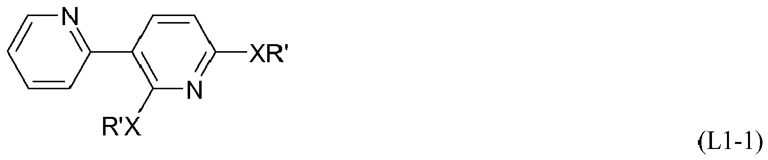 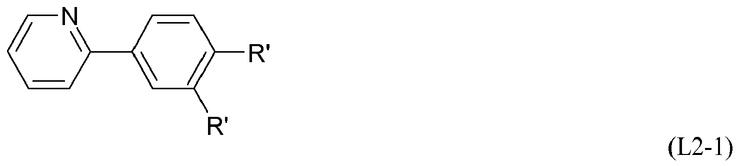 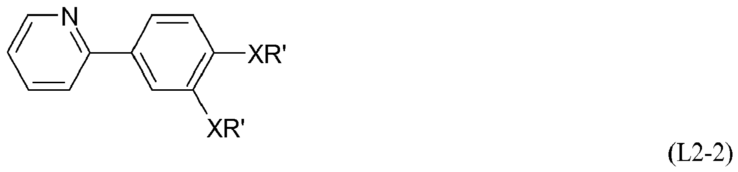 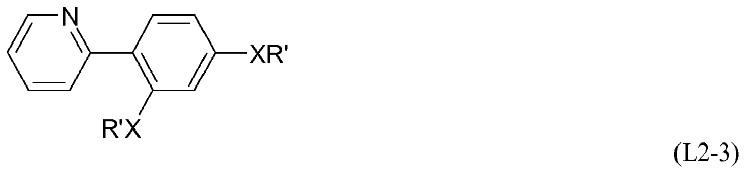 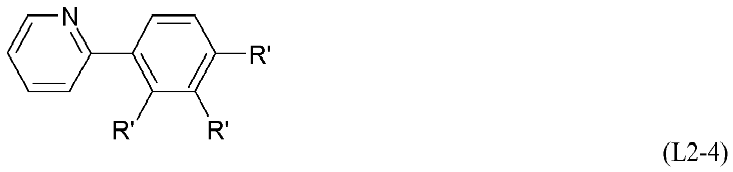 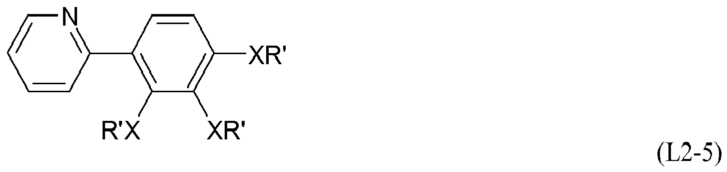 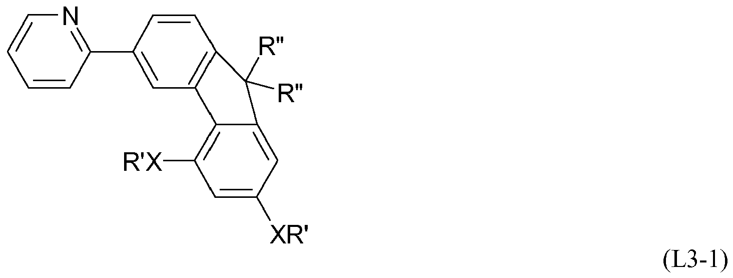 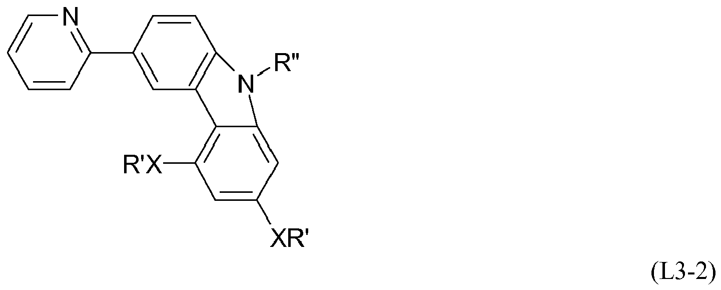 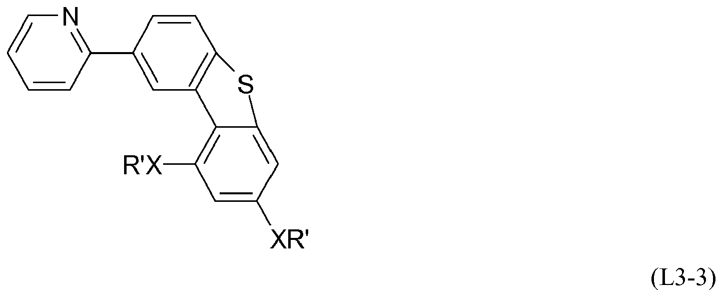 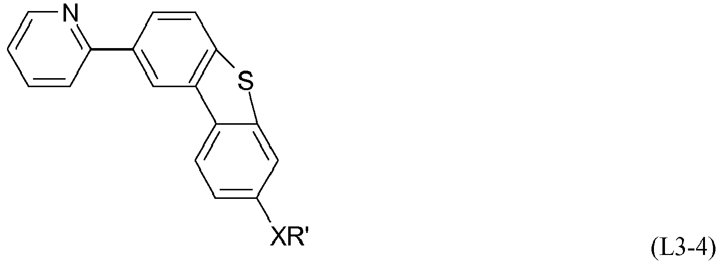 wherein X is independently selected from the group consisting of NR', O and S, R' is independently selected from the group consisting of alkyl groups, halogenated alkyl groups, aryl groups, halogenated aryl groups, and any derivatives of the foregoing groups wherein at least one of the carbon atom in the foregoing group is replaced by N, O and/or S, and any combination thereof, and R" is independently selected from the group consisting of hydrogen, alkyl groups, halogenated alkyl groups, aryl groups, halogenated aryl groups, and any derivatives of the foregoing groups wherein at least one of the carbon atom in the foregoing group is regularly or randomly replaced by N, O and/or S, and any combination thereof, provided at least one R' comprises 4 or more carbon atoms.

11. The metal complex according to claim 9 or 10, wherein La has the formula (B) or the formula (II) and Lb has the formula (III) below : 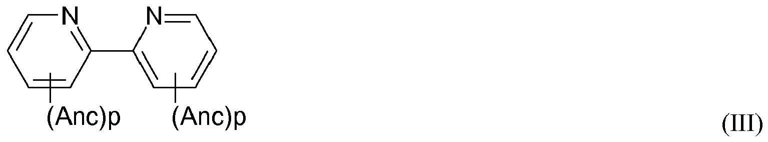 wherein Anc is independently selected from anchoring groups, and p is independently 1, 2, 3 or 4, preferably 1.

12. The metal complex according to any one of claims 9 to 11, wherein the anchoring group is selected from the group consisting of -COOH, -PO₃H₂, -P(=O)(Ra)(OH) (wherein Ra is selected from the groups consisting of optionally branched C1-C18 alkyl groups and optionally substituted C5-C12 aryl groups, and halogenated derivatives thereof), -PO₄H₂, -PO₂HRb (wherein Rb is selected from alkyl groups or aryl groups), -SO₃H, -CONHOH, -NO₂, acetylacetonate, acrylic acid derivatives, malonic acid derivative, rhodanine-3-acetic acid, propionic acid, deprotonated forms of the aforementioned, salts of said deprotonated forms, and chelating groups with π-conducting character, in particular from the group consisting of -COOH, and salts of the deprotonated forms of the aforementioned.

13. The metal complex according to any one of claims 9 to 12, having the formula (I-1) below : 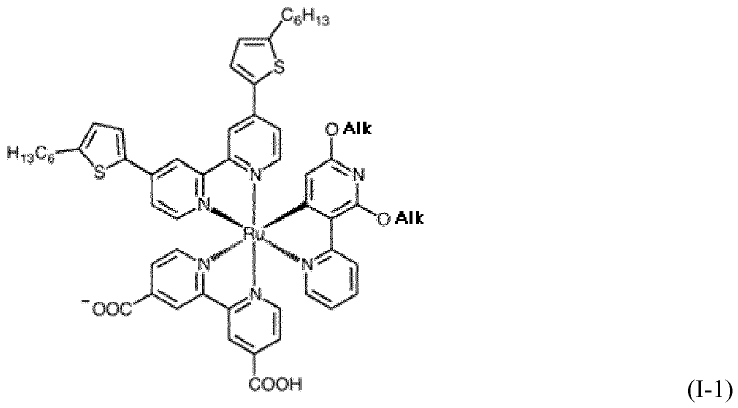 wherein Alk is alkyl groups having 4 or more carbon atoms.

14. A ligand having a structure selected from the group consisting of the formulae (L1-1), (L2-1), (L2-2), (L2-3), (L2-4), (L2-5), (L3-1), (L3-2), (L3-3) and (L3-4) : 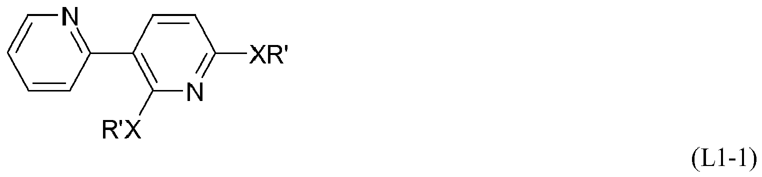 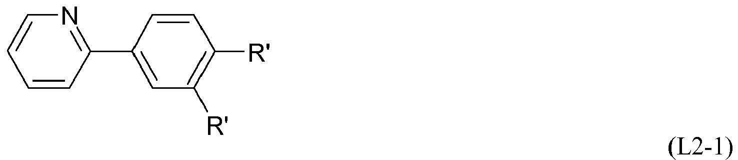 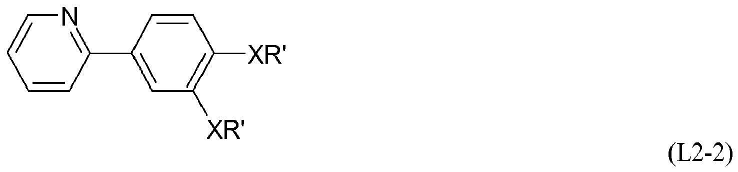 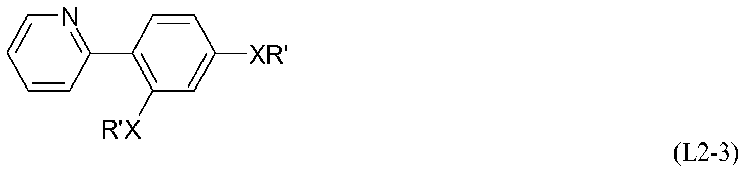 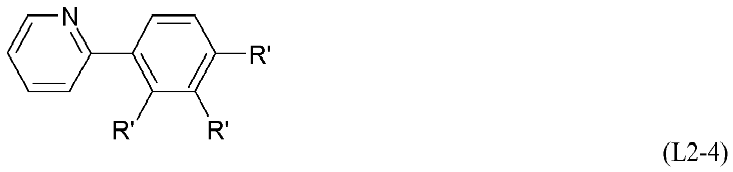 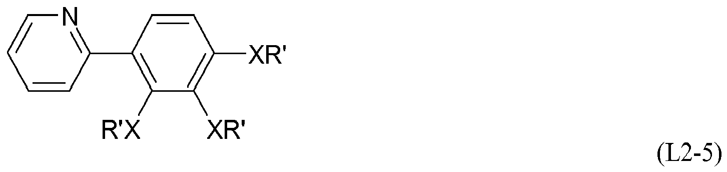 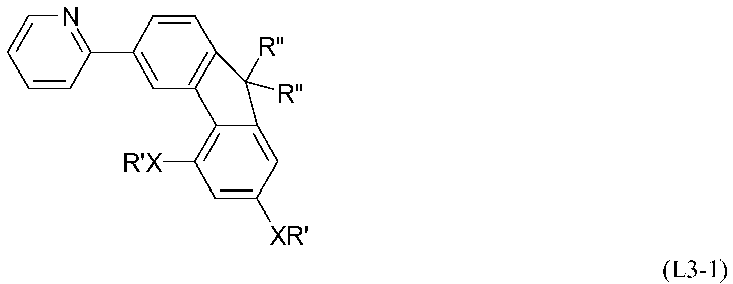 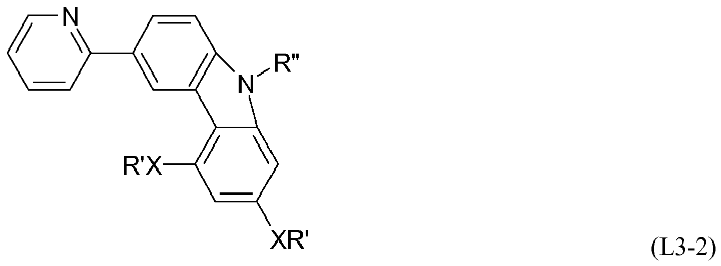 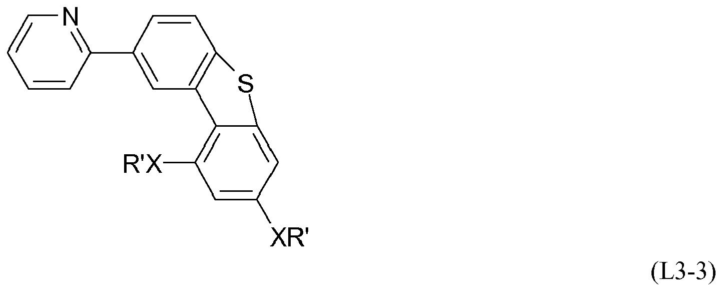 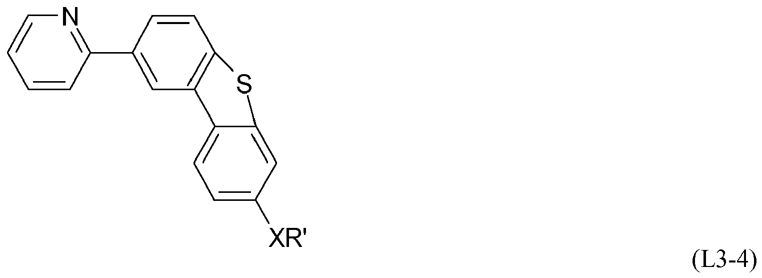 wherein X is independently selected from the group consisting of NR', O and S, R' is independently selected from the group consisting of alkyl groups, halogenated alkyl groups, aryl groups, halogenated aryl groups, and any derivatives of the foregoing groups wherein at least one of the carbon atom in the foregoing group is replaced by N, O and/or S, and any combination thereof,
and R" is independently selected from the group consisting of hydrogen, alkyl groups, halogenated alkyl groups, aryl groups, halogenated aryl groups, and any derivatives of the foregoing groups wherein at least one of the carbon atom in the foregoing group is replaced by N, O and/or S, and any combination thereof, provided at least one R' comprises 4 or more carbon atoms.
